# EUROPÄISCHE PATENTANMELDUNG

(11) **EP 4 246 598 A1**
(43) Veröffentlichungstag der Anmeldung: **20.09.2023**
(21) Anmeldenummer: 22162470.3
(22) Anmeldetag: 16.03.2022
(51) Int. Cl.: H01L 31/0368, C23C 14/14, C23C 14/34, H01L 31/0747, H01L 31/18

(54) **VERFAHREN UND VAKUUMSYSTEM**

(71) Anmelder: VON ARDENNE Asset GmbH & Co. KG, 01328 Dresden (DE)
(72) Erfinder: SCHNEIDERLÖCHNER, Eric, 01099 Dresden (DE); LINß, Volker, 01324 Dresden (DE); BAUMANN, Jens, 09114 Chemnitz (DE); DIETSCH, Tina, 01277 Dresden (DE)
(74) Vertreter: Viering, Jentschura & Partner mbB Patent- und Rechtsanwälte

(57) **Zusammenfassung**

Gemäß verschiedenen Ausführungsformen kann ein Verfahren (300) zum Bearbeiten eines Solarzellenpräkursors (402), welcher eine mit zumindest einem Dielektrikum beschichtete Seite aufweist, aufweisen: Zerstäuben (303) eines Sputtertargets (404) in einen Beschichtungsbereich (401) hinein, wobei das Sputtertarget (404) ein Halbleitermaterial aufweist; wobei das Sputtertarget (404) ferner einen Dotanten des Halbleitermaterials aufweist in einer Menge, die größer ist als eine Löslichkeitsgrenze des Dotanten in dem Halbleitermaterial und/oder als ein Massenanteil des Dotanten von 0,15%; Anordnen (305) des Solarzellenpräkursors (402), der in einem Substratträger eingelegt ist, in dem Beschichtungsbereich (401), wenn das Zerstäuben des Sputtertargets (404) in den Beschichtungsbereich (401) hinein erfolgt derart, dass die Seite dem Sputtertarget (404) zugewandt ist; wobei der Substratträger derart eingerichtet ist, dass eine entlang eines in sich geschlossenen Pfades verlaufende Kante (510k, 512k) des Solarzellenpräkursors (402) mittels des Substratträgers gegenüber dem Zerstäuben des Sputtertargets (404) abgeschattet wird.

## Beschreibung

Verschiedene Ausführungsbeispiele betreffen ein Verfahren.

Seit der Entwicklung und Kommerzialisierung der Solarzelle zur Energiegewinnung steht unter anderem deren Wirkungsgrad als zentraler Optimierungsparameter im Vordergrund. Seither wurden verschiedene Solarzellentechnologien entwickelt, um den Wirkungsgrad zu erhöhen, möglichst ohne das Verhältnis aus Nutzen und Herstellungskosten zu verringern. Eine diese Solarzellentechnologien ist die sogenannte PERC-Technologie ("Passivated Emitter and Rear Cell"), bei der eine Rückseitenpassivierung mit Hilfe einer dielektrischen Dünnschicht zum Einsatz kommt, welche die Lichtausbeute vergrößert. Seither hat sich herausgestellt, dass die noch verbliebenen Rekombinationsverluste an den metallischen Kontakten, welche die Rückseitenpassivierung der PERC-Technologie durchstoßen, den Wirkungsgrad noch immer wesentlich limitieren.

Gemäß verschiedenen Ausführungsformen kommt als Weiterentwicklung der PERC-Technologie ein sogenannter passivierter Kontakt zum Einsatz, welcher diese Rekombinationsverluste verringert. Diesem passivierten Kontakt ist eigen, dass dessen Metallisierung dielektrisch separiert ist vom Halbleiterübergang der Solarzelle. In einer beispielhaften Implementierung wird der passivierte Kontakt als Tunneloxid-passivierter Kontakt (als sogenannter TOPCon) ausgebildet, der einen Stapel aufweist aus einer dünnen, z.B. 1-3 nm (Nanometer) dicken, Tunneloxidschicht (z.B. aus SiOx), darüber einer polykristallinen dotierten Siliziumdünnschicht, darüber eine optionale dielektrische Schicht geeigneter Dicke und mit geeignetem Brechungsindex (z.B. aus SiNx:H) zur Verbesserung der Lichteinkopplung in bifazialen PV-Module sowie zur Bereitstellung von Wasserstoff, und darüber einer Metallisierung. Die TOPCon-Technologie stellt einen Wirkungsgrad von mehr als 24% in Aussicht, beispielsweise für eine siliziumbasierte Solarzelle.

Gemäß verschiedenen Ausführungsformen wurde erkannt, dass die bisher zur Herstellung von Solarzellen etablierten Prozesse, wenn diese auch für die Herstellung passivierter Kontakte dienen, hohe Kosten verursachen. Die dotierte Siliziumdünnschicht kann zwar aus technischer Sicht mittels der etablierten chemischen Gasphasenabscheidung (CVD) hergestellt werden, z.B. einer plasmaunterstützten CVD (PECVD) oder einer Niederdruck-CVD (LPCVD). Allerdings kommen bei dieser CVD giftige Gase zum Einsatz und diese ist auch in der Skalierbarkeit begrenzt. Ferner ist häufig eine Nachbearbeitung der Solarzelle nach dem CVD-Prozess nötig, da die Deposition allumseitig erfolgt, so dass auch eine störende Beschichtung der Waferkante (auch als Kantenumgriff bezeichnet) bzw. der Seitenfläche sowie zumindest teilweise (d.h. teilweise oder vollständig) der dem Beschichtungsprozess abgewandten Seite des Wafers erfolgt. Aufgrund dieses Kantenumgriffs kann eine elektrisch leitfähige Verbindung zwischen dem üblicherweise p-leitend dotiertem Gebiet der Vorderseite und dem üblicherweise n-leitend dotiertem Gebiet der Rückseite der Solarzelle begünstigt werden, was die Solarzelle elektrisch kurzschließt und deren Wirkungsgrad bzw. deren Rückwärtsstromverhalten nachhaltig beeinträchtigt.

Um diesen Kantenumgriff wieder zu entfernen, sind zusätzliche Prozessschritte erforderlich, z.B. nasschemisches Ätzen. Diese zusätzlichen Prozessschritte verursachen zusätzliche Kosten und erhöhen das Risiko für zusätzlichen Ausschuss im Fertigungsablauf, so dass im Ergebnis der Aufwand der Umsetzung den Nutzen schnell überwiegt und eine ökonomisch sinnvolle Realisierung in der Massenfertigung bislang nicht erfolgt ist. Neben den damit verbundenen Kosten führen gegenwärtig verfügbare Prozesstechnologien, die zur Entfernung des zu viel deponierten Materials eingesetzt werden, zu erheblichen, nicht tolerierbaren Ausschussverlusten (elektrisch und optisch), die dem gewinnbringenden Einsatz in der Massenfertigung entgegenstehen.

Vor diesem Hintergrund ist bisher kein Einsatz von passivierten Kontakten in der Massenfertigung von Solarzellen erfolgt, trotz der potentiellen Erhöhung des Wirkungsgrads.

Gemäß verschiedenen Ausführungsformen wird ein Verfahren bereitgestellt, das die Wirtschaftlichkeit der Herstellung von Solarzellen verbessert bzw. deren Herstellung erleichtert. Anschaulich wurde erkannt, dass sich der Großteil der oben erläuterten Hürden überwinden lässt, indem unter anderem eine physikalische Gasphasenabscheidung (PVD), vorzugsweise das Sputtern, zum Einsatz kommt, beispielsweise verbunden mit einer Verschattungsmaske und/oder einer geringen Beschichtungstemperatur. Anschaulich verbessern diese Maßnahmen die Schichteigenschaften, beispielsweise hinsichtlich der Stöchiometrie, der Verwendung giftiger flüchtiger Stoffe, und/oder der Tendenz zur Entstehung des Kantenumgriffs. Die geringere Beschichtungstemperatur trägt beispielsweise dazu bei, Energie zu sparen, die Entstehung giftiger flüchtiger Stoffe zu hemmen und hemmt das Risiko, dass die gebildete Schicht abplatzt.

Gemäß verschiedenen Ausführungsformen wird ferner eine Vakuumanordnung (z.B. Vakuumanlage) bereitgestellt für die Beschichtung von Siliziumwafern mit einem Schichtstapel zur Herstellung eines passivierten Kontakts mittels eines PVD-Verfahrens (beispielsweise für die Massenfertigung von Silizium-Solarzellen mit passivierten Kontakten). Beispielsweise wird ein passivierter Kontakt auf Basis eines Tunneloxids und einer dotierten polykristallinen Siliziumschicht bereitgestellt. Der in der Siliziumschicht erwünschte Dotierstoff, im n-dotierten Fall beispielsweise Phosphor, kann dann auch im darauffolgenden Hochtemperaturschritt eingetrieben werden, um aus der abgeschiedenen amorphen oder teilkristallinen Siliziumschicht eine polykristalline Siliziumschicht zu erzeugen. In der Folge entsteht somit der angestrebte elektrisch leitfähige Schichtstapel zur Ausbildung eines passivierten Kontakts (dann als TOPCon bezeichnet).

Es zeigen
- Figur 1 und 2: jeweils eine Solarzelle gemäß verschiedenen Ausführungsformen in einem schematischen Aufbaudiagramm im Querschnitt;
- Figur 3: ein Verfahren gemäß verschiedenen Ausführungsformen in einem schematischen Ablaufdiagramm;
- Figur 4: eine Vakuumanordnung in Sputter-Up-Konfiguration gemäß verschiedenen Ausführungsformen in einer schematischen Querschnittsansicht;
- Figur 5A und B: jeweils den Solarzellenpräkursor gemäß verschiedenen Ausführungsformen in verschiedenen Ansichten;
- Figur 6: eine Vakuumanordnung in Sputter-Down-Konfiguration gemäß verschiedenen Ausführungsformen in einer schematischen Querschnittsansicht;
- Figur 7A bis C: jeweils den Solarzellenpräkursor gemäß verschiedenen Ausführungsformen in verschiedenen Ansichten;
- Figur 8: ein Arbeitsergebnis gemäß verschiedenen Ausführungsformen in einem schematischen Diagramm;
- Figur 9 und 10: jeweils eine Vakuumanordnung gemäß verschiedenen Ausführungsformen in einer schematischen Querschnittsansicht;
- Figur 11A und 11B: jeweils den Substratträger gemäß verschiedenen Ausführungsformen in verschiedenen Ansichten; und
- Figur 12: eine Beschichtungsanordnung gemäß verschiedenen Ausführungsformen in einer schematischen Seitenansicht oder Querschnittsansicht.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Bezüglich der hierin erläuterten chemischen Verbindungen, wie beispielsweise Oxide, Karbide und/oder Nitride, kann verstanden werden, dass diese stöchiometrisch oder auch unterstöchiometrisch (d.h. Leerstellen aufweisend) sein können. Unterstöchiometrisches Siliziumoxid kann beispielsweise angegeben werden als SiO_{2-y} (y>1), oder kurz SiOx (x=2-y).

Hierin wird Bezug genommen auf verschiedene Angaben über die Menge eines Materials, beispielsweise
- im Verhältnis zu der Menge eines Referenzmaterials (auch als Mengenverhältnis bezeichnet, z.B. angegeben als Dotierungsstärke (z.B. als Atomanzahlverhältnis) oder als Massenverhältnis;
- als Anteil, beispielsweise an der Gesamtmasse (dann auch als Massenanteil bezeichnet, z.B. angegeben als gew%) einer Referenz, an dem Gesamtvolumen (dann auch als Volumenanteil bezeichnet, z.B. angegeben als vol%) der Referenz oder der Stoffmenge der Referenz (dann auch als Stoffmengenanteil bezeichnet, z.B. angegeben als at%), wobei die Referenz das Material aufweist, oder
- als Konzentration (z.B. angegeben als Atomanzahl pro Volumen, z.B. in at/cm³).

Als Referenz kann beispielsweise der Körper (z.B. das Sputtertarget oder eine Schicht) dienen, welcher das Material aufweist, oder ein Materialgemisch (z.B. aus Halbleitermaterial und Dotant) dienen, welches das Material aufweist. Das Materialgemisch kann beispielsweise ein Zweistoffgemisch sein. Das Referenzmaterial kann beispielsweise ein anderes Material als das Material sein, z.B. das Halbleitermaterial.

Hierin wird ferner Bezug genommen auf die Reinheit (auch als Stoffreinheit bezeichnet) eines Materials in der Referenz, beispielsweise einem Stoffgemisch (worunter auch das wenig verunreinigte Material fällt), beispielsweise einem Festkörper aus dem Stoffgemisch. Die Reinheit wird angeben als Stoffmengenanteil des Materials an der Referenz, z.B. als 99,9 at%. Im Fall eines hochreinen Materials ist die Reinheit in der Regel größer als 99 at%, wobei eine oder mehr als eine der Nachkommastellen häufig den Wert 9 aufweisen. Vereinfachend wird auch nur die summierte Anzahl z der Neunen (vor und nach dem Komma) des Werts der Reinheit angegeben gefolgt von dem Buchstaben N (wobei z eine natürliche Zahl ist), beispielsweise als "6N", wenn z=6 ist. Die Reinheit ist dann (10^{z}-1)/10^{(z-2)} at%. Eine Reinheit von 6N bedeutet demnach, dass der Wert der Reinheit mindestens 99,9999 at% ist. Eine optionale zusätzliche Ziffer nach dem N gibt die der Reihe von Neunen folgende Zahl an. Eine Reinheit von 3N5 bedeutet beispielsweise 99,95 at%.

Hierin wird Bezug genommen auf ein Verfahren und eine Vakuumanordnung (z.B. deren Vakuumsystem), die beispielsweise eingerichtet ist zum Durchführen des Verfahrens, im Zusammenhang mit dem Bearbeiten eines Solarzellenpräkursors (auch als Solarzellensubstrat oder als teilprozessierte Solarzelle bezeichnet) als exemplarisches Substrat. Es kann verstanden werden, dass das für den Solarzellenpräkursor Beschriebene für jedes andere Substrat gelten kann, welches mit einem oder mehr als einem Dielektrikum, vorzugsweise aus einem Oxid (z.B. Halbleiteroxid, z.B. Siliziumoxid), beschichtet ist. Bezüglich der Beschichtung und/oder bezüglich des Bearbeitens kann ferner verstanden werden, dass das für eine konkrete Seite (z.B. Rückseite oder Vorderseite) des Solarzellenpräkursors (bzw. Substrats) Beschriebene in Analogie gelten kann für die jeweils gegenüberliegende Seite (dann Vorderseite bzw. Rückseite) des Solarzellenpräkursors (bzw. Substrats). Mit anderen Worten kann das hierin beschriebene Bearbeiten des Solarzellenpräkursors (bzw. Substrats) nur auf dessen Vorderseite, nur auf dessen Rückseite oder auch auf jede der beiden Seiten (z.B. nacheinander), nämlich Vorderseite und Rückseite, angewendet werden.

Herkömmlicherweise wird die polykristalline, dotierte Siliziumschicht des passivierten Kontakts mittels einer chemischen Gasphasenabscheidung (CVD) hergestellt, beispielsweise mittels Niederdruck-CVD (LPCVD), mittels plasmaunterstützter CVD (PECVD) oder CVD-Abscheidung bei Normaldruck (APCVD). Im Gegensatz zur PVD wird bei der CVD eine gasförmige Ausgangsverbindung (auch als Präkursorgas oder Edukt bezeichnet) in mindestens zwei Reaktionsprodukte aufgespalten wird, von denen zumindest ein Reaktionsprodukt in die Schicht eingebaut wird und optional ein Reaktionsprodukt als Überschuss dem Beschichtungsprozess (z.B. mittels einer Pumpe) entzogen wird. Optional kann die CVD mittels eines Plasmas erfolgen, in welchem das Aufspalten des Präkursors erfolgt (dann auch als PECVD bezeichnet).

Das hierin beschriebene Verfahren kann aufweisen, einen passivierten Kontakt oder einen Vorläufer dessen zu bilden, beispielsweise auf der Solarzellenrückseite und/oder auf der Solarzellenvorderseite (anschaulich der Sonne zuzuwendenden Seite).

Bezüglich des schichtbildenden Prozesses wird hierin exemplarisch auf das sogenannte Sputtern Bezug genommen. Der Begriff "Sputtern" bezeichnet das Zerstäuben eines Materials (auch als Beschichtungsmaterial oder Targetmaterial bezeichnet) mittels eines Plasmas. Die zerstäubten Bestandteile des Beschichtungsmaterials (z.B. einzelne Atome und/oder Ionen) werden voneinander separiert und können beispielsweise zum Bilden einer Schicht woanders angelagert werden. Das Sputtern kann mittels einer sogenannten Sputtervorrichtung erfolgen, welche ein oder mehr als ein Magnetsystem aufweisen kann (dann auch als Magnetron bezeichnet). Das Beschichtungsmaterial kann mittels eines sogenannten Sputtertargets (kurz auch als Target bezeichnet) bereitgestellt sein, welches beispielsweise rohrförmig (dann auch als Rohrtarget bezeichnet) oder plattenförmig (dann auch als Plattentarget oder Planartarget bezeichnet) sein kann. Zum Erzeugen des Plasmas kann an das Sputtertarget (kurz auch als Target bezeichnet) eine Spannung (auch als Sputterspannung bezeichnet) angelegt werden, so dass das Sputtertarget als Kathode betrieben wird. Auch wenn die Sputterspannung eine Wechselspannung aufweist, wird die Begrifflichkeit der Kathode häufig beibehalten.

Zum Sputtern kann das Sputtertarget in einer Vakuum-Prozessierkammer (vereinfacht auch als Prozessierkammer bezeichnet) angeordnet sein, so dass das Sputtern in einem Vakuum erfolgen kann. Dazu können die Umgebungsbedingungen (die Prozessparameter) innerhalb der Vakuum-Prozessierkammer (z.B. Prozessdruck, Temperatur, Gaszusammensetzung, usw.) während des Sputterns eingestellt oder geregelt werden. Beispielsweise kann innerhalb der Prozessierkammer ein Arbeitsgas bereitgestellt sein oder werden, welches das plasmabildende Gas oder das plasmabildende Gasgemisch bezeichnet. Die Prozessierkammer kann beispielsweise luftdicht, staubdicht und/oder vakuumdicht eingerichtet sein oder werden, so dass innerhalb der Prozessierkammer eine Gasatmosphäre mit einer vordefinierten Zusammensetzung (auch als Arbeitsatmosphäre bezeichnet) oder einem vordefinierten Druck (auch als Arbeitsdruck oder Prozessdruck bezeichnet) bereitgestellt werden kann (z.B. gemäß einem Sollwert), z.B. ein Vakuum.

Das Plasma kann mittels eines sogenannten Arbeitsgases (auch als plasmabildendes Gas bezeichnet) gebildet werden. Gemäß verschiedenen Ausführungsformen kann das Arbeitsgas ein gasförmiges Material aufweisen, welches reaktionsträge ist, mit anderen Worten welches sich nur an wenigen oder gar keinen chemischen Reaktionen beteiligt. Ein Arbeitsgas kann beispielsweise von dem verwendeten Targetmaterial definiert sein oder werden und an dieses angepasst sein oder werden. Beispielsweise kann ein Arbeitsgas ein Gas oder ein Gasgemisch aufweisen, welches mit dem Targetmaterial nicht zu einem Feststoff reagiert oder diesem gegenüber sogar inert ist. Das Arbeitsgas kann beispielsweise ein Edelgas (z.B. Helium, Neon, Argon, Krypton, Xenon, Radon) oder mehrere Edelgase aufweisen. Aus dem Arbeitsgas kann das Plasma gebildet werden, welches beispielsweise im Wesentlichen das Zerstäuben des Targetmaterials bewirkt. Wird ein Reaktivgas verwendet, kann dieses eine höhere chemische Reaktivität als das Arbeitsgas aufweisen, z.B. bezüglich des Targetmaterials. Mit anderen Worten kann das zerstäubte Targetmaterial zusammen mit dem Reaktivgas (wenn vorhanden) schneller reagieren (d.h. mehr Reaktionsprodukt pro Zeit bilden) als zusammen mit dem Arbeitsgas (z.B. wenn es überhaupt mit dem Arbeitsgas chemisch reagiert). Das Reaktivgas und das Arbeitsgas können gemeinsam oder getrennt als Prozessgas (z.B. als Gasgemisch) zugeführt werden, beispielsweise mittels der Gaszuführvorrichtung.

Es kann verstanden werden, dass das hierin für das Sputtern Beschriebene in Analogie für jeden anderen Beschichtungsprozess, z.B. eine physikalische Gasphasenabscheidung, gelten kann. Im Allgemeinen weist die physikalische Gasphasenabscheidung (z.B. das Sputtern) auf, dass die chemische Zusammensetzung des Targets bzw. des Beschichtungsmaterials in die zu bildende Schicht übertragen wird, beispielsweise das zerstäubte Target nicht mit einem Reaktivgas wechselwirkt (z.B. reagiert), was auch als reaktive PVD bezeichnet wird. Bei Verwendung eines Reaktivgases kann eine Schicht, die das Reaktionsprodukt von Targetmaterial und Reaktivgas aufweist, gebildet werden. Beispielsweise kann das Bilden einer SiNx:H-Schicht unter Verwendung eines Si-Targets zusammen mit NH3 (Ammonikgas) als Reaktivgas erfolgen.

Im Gegensatz zur CVD wird bei der PVD, z.B. dem Sputtern, ein festes Material zunächst in die Gasphase (auch als gasförmige Phase oder Dampf bezeichnet) überführt und mittels dieser Gasphase eine Schicht gebildet. Die Gasphase des Targetmaterials kann bei der PVD optional (z.B. bei einer reaktiven PVD) chemisch reagiert werden (beispielsweise dann auch als reaktives PVD bzw. Sputtern bezeichnet) mit einem Reaktivgas zu einer chemischen Verbindung, welches in die Schicht eingebaut wird oder diese bildet. Bei der chemischen Reaktion der PVD werden somit zwei oder mehr Materialien zu der chemischen Verbindung zusammengeführt.

Mittels Sputterns wird beispielsweise eine teilkristalline bis amorphe Siliziumdünnschicht gebildet, die mittels eines anschließenden Hochtemperaturschritts zur Dotierung und/oder Kristallisation (sogenannte "solid phase crystallization") nachbehandelt wird.

Hierin wird zum vereinfachten Verständnis Bezug genommen auf eine n-Dotierung als exemplarische Dotierung ersten Typs (z.B. n-Typs bzw. Donor-Typs) und eine p-Dotierung als exemplarische Dotierung zweiten Typs (z.B. p-Typs bzw. Akzeptor-Typs). Beispielsweise wird der physische Aufbau einer Solarzelle (z.B. in TOPCon-Technologie) erläutert anhand einer n-dotierten Basisschicht (z.B. einen Siliziumwafer aufweisend) mit einer p-dotierten Emitterschicht (beispielsweise mittels Bor dotiert). Es kann im Allgemeinen verstanden werden, dass das für diese exemplarischen Dotierungen Beschriebene in Analogie gelten kann für eine entgegengesetzte Dotierung.

Im Allgemeinen kann der passivierte Kontakt (z.B. TOPCon) einen Schichtstapel aufweisen, der eine dotierte Halbleiterschicht (auch als Vermittlerschicht bezeichnet) aufweist. Die Vermittlerschicht stimmt mit der Basisschicht in ihrem Dotierungstyp (z.B. n-Typ oder p-Typ) überein und unterscheidet sich von der Emitterschicht in ihrem Dotierungstyp. In einer exemplarischen Implementierung weist die Solarzelle auf der der Sonne zuzuwendenden Seite, der Vorderseite der Solarzelle, die p-dotierte Emitterschicht und auf der der Sonne abzuwendenden Seite, der Rückseite der Solarzelle, einen n-dotierten passivierten Kontakt auf. Das Beschriebene kann also ebenso gelten für eine Solarzelle mit einer p-dotierten Basisschicht und einer n-dotierten Emitterschicht bzw. einem p-dotierten passivierten Kontakt.

Weitere Beispiele für Solarzellen, in denen passivierte Kontakte zum Einsatz kommen können, weisen beidseitig mit passivierten Kontakten ausgestatte Solarzellen (anschaulich eine Variante der Heterojunction-Solarzelle) auf, sowohl ganzflächig als auch lokal begrenzt auf den Einsatz des passivierenden Kontaktschichtstapels auf Bereiche unterhalb der metallischen Kontakte, sowie nur auf der sonnenabgewandten Rückseite kontaktierte Solarzellen, bei denen beide Ladungsträgerarten (Elektronen und Löcher) auf einer Seite der Solarzelle über elektrische Kontakte nach außen abgeführt werden.

Ferner wird hierin auf eine Metallisierung (z.B. Rückseitenmetallisierung oder Vorderseitenmetallisierung) Bezug genommen, beispielsweise als Bestandteil des passivierten Kontakts. Diese Metallisierung kann, muss aber nicht zwangsläufig, auch gebildet werden, nachdem der Solarzellenpräkursor aus dem Beschichtungsbereich heraus transportiert wurde, beispielsweise nachdem dieser aus der Vakuumanordnung (z.B. dem darin bereitgestellten Vakuum) herausgeschleust wurde. Diese Metallisierung kann beispielsweise gebildet werden mittels Siebdrucks, oder eines anderes Druckprozesses, wie beispielsweise Inkjet, Rotations- oder Extrusionsdruck, oder mittels Galvanisierens (engl. "plating").

Bezüglich des passivierten Kontakts wird hierin exemplarisch auf den Tunneloxidpassivierten Kontakt (TOPCon) Bezug genommen. Das hierin exemplarisch für den TOPCon Beschriebene kann in Analogie gelten für jeden passivierten Kontakt anderen Typs, der beispielsweise nicht unbedingt ein Tunneloxid aufweisen muss, beispielsweise stattdessen ein anderes Oxid oder ein Nitrid.

Der Begriff "Löslichkeitsgrenze" im Kontext eines Dotanten in einem Halbleitermaterial bezeichnet anschaulich die obere Grenze der Menge des Dotanten in einem festen Gemisch (aus dem Dotanten und dem Halbleitermaterial), bis zu welcher das Gemisch beim Erstarren und/oder bei Normalbedingungen (293,15 Kelvin und 1,01325 bar) ein homogenes Gemisch bildet. Ist die Menge des Dotanten in dem Halbleitermaterial größer als die Löslichkeitsgrenze, entmischt sich das Gemisch, beispielsweise wenn dieses von der Schmelztemperatur des Gemischs, welche beispielsweise ungefähr die Schmelztemperatur des Halbleitermaterials sein kann (d.h. weniger als 10% davon abweicht), auf Normalbedingungen abgekühlt wird. Generell ist die Löslichkeitsgrenze hierin auf Normalbedingungen bezogen. Die Löslichkeitsgrenze SG kann beispielsweise kleiner als ungefähr 10²⁰ at/cm³ (hierin auch angegeben als 1E20 at/cm³), z.B. kleiner als 5·10¹⁹ at/cm³, wenn der Dotant Bor, Phosphor, Arsen oder Antimon ist und das Halbleitermaterial Silizium ist.

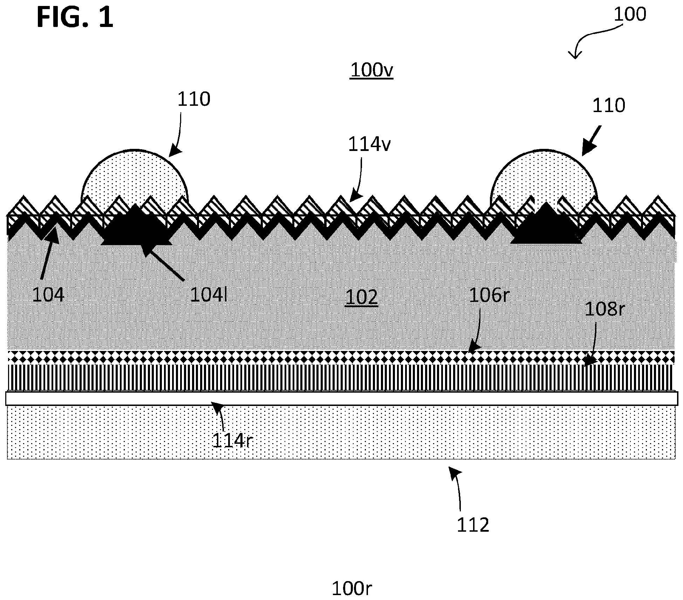

**Fig.1** veranschaulicht eine Solarzelle gemäß verschiedenen Ausführungsformen 100 in einem schematischen Aufbaudiagramm im Querschnitt. Der hier gezeigte Aufbau betrifft die fertig produzierte Solarzelle, welche (beispielsweise zusammen mit einer oder mehr als einer zusätzlichen Solarzelle) zu einem Modul (auch als Solarzellenmodul oder Solarmodul bezeichnet) weiterverarbeitet werden kann, indem deren Metallisierungen 110, 112 elektrisch mit einem Anschlussterminal und/oder einer zusätzlichen Solarzelle verbunden werden. Der Solarzellenpräkursor bezeichnet anschaulich den Vorläufer der Solarzelle, der bereits einige, aber nicht notwendigerweise alle Komponenten der Solarzelle, aufweisen kann, wie nachfolgend erläutert ist.

Der Solarzellenpräkursor weist eine dotierte (z.B. n-dotierte) erste Halbleiterschicht 102 (auch als Basisschicht bezeichnet), z.B. einen Wafer, auf, die zwischen einer Vorderseite 100v und einer Rückseite 100r des Solarzellenpräkursor angeordnet ist. Die Vorderseite 100v des Solarzellenpräkursor kann optional texturiert und/oder strukturiert sein. Dies verbessert die Lichtaufnahme.

Der Solarzellenpräkursor weist ferner eine an die Basisschicht 102 angrenzende und/oder der Vorderseite 100v zugewandte dotierte (z.B. p-dotierte) zweite Halbleiterschicht 104 (auch als Emitterschicht 104 bezeichnet) auf. Die Basisschicht 102 und die Emitterschicht 104 können einen (beispielsweise bipolaren) Halbleiterübergang (dann auch als pn-Übergang bezeichnet) bilden, beispielsweise wenn diese sich in ihrem Dotierungstyp (z.B. n-Typ oder p-Typ) voneinander unterscheiden.

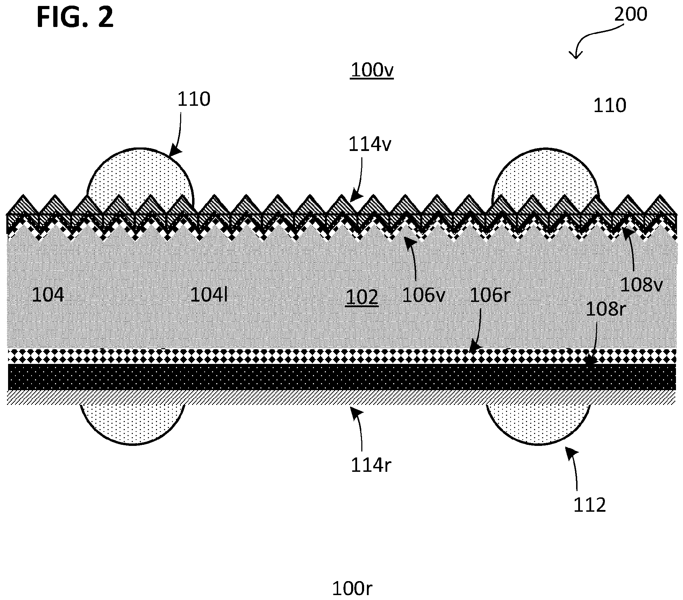

Der Solarzellenpräkursor weist ferner eine oder mehr als eine dielektrische Schicht (auch als Passivierungsschicht oder vereinfacht als Passivierung bezeichnet) auf (vergleiche hierzu auch Fig.2), welche beispielsweise ein oder mehr als ein Dielektrikum (auch als Passivierungsdielektrikum bezeichnet) aufweist oder daraus besteht. Beispiele für die eine oder mehr als eine Passivierungsschicht weisen auf: eine erste Passivierungsschicht 106v (auch als Vorderseitenpassivierung 106v bezeichnet, siehe auch Fig.2) auf der Vorderseite 100v (dann auch als passivierte Vorderseite 100v bezeichnet) und/oder eine zweite Passivierungsschicht 106r (auch als Rückseitenpassivierung 106r bezeichnet) auf der Rückseite 100r (dann auch als passivierte Rückseite 100r bezeichnet).

Die Basisschicht 102 ist zwischen der Rückseitenpassivierung 106r, insofern vorhanden, und der Emitterschicht 104 angeordnet. Die Rückseitenpassivierung 106r kann beispielsweise als Tunneloxidschicht ausgebildet sein. Dann kann diese beispielsweise eine Dicke aufweisen von weniger als ungefähr 5 Nanometer (nm), z.B. weniger als ungefähr 2 Nanometer (nm) und/oder in einem Bereich von ungefähr 1 nm bis ungefähr 2 nm.

Das Passivierungsdielektrikum kann beispielsweise ein Halbleitermaterial (z.B. Silizium) aufweisen, z.B. in einer chemischen Verbindung und/oder das Halbleitermaterial der Basisschicht 102. Beispiele für das eine oder mehr als eine Passivierungsdielektrikum weisen auf: eine chemische Verbindung aus einem Halbleitermaterial und Sauerstoff, eine chemische Verbindung aus einem Halbleitermaterial und Kohlenstoff, eine chemische Verbindung aus einem Halbleitermaterial und Stickstoff, ein Oxid, ein Karbid, ein Nitrid oder Mischungen daraus. Beispielsweise weist die Rückseitenpassivierung 106r ein Halbleiteroxid (z.B. Siliziumoxid) auf oder besteht daraus.

Das hierin beschriebene Bearbeiten des Solarzellenpräkursors kann aufweisen, eine passivierte Seite (z.B. Rückseite 100r und/oder Vorderseite 100v) des Solarzellenpräkursors zu bearbeiten, z.B. zu beschichten mit einer amorphen und/oder dotierten Schicht (auch als Vermittlerschicht bezeichnet), welche z.B. die Passivierungsschicht auf der Seite (z.B. elektrisch und/oder physisch) kontaktiert. Das Bearbeiten der passivierten Seite (z.B. Rückseite 100r und/oder Vorderseite 100v) des Solarzellenpräkursors kann mittels einer physikalischen Gasphasenabscheidung (PVD) erfolgen, wie später noch genauer erläutert wird.

Bezogen auf die hier dargestellte Solarzelle kann das Bearbeiten des Solarzellenpräkursors aufweisen, die passivierte Rückseite 100r zu bearbeiten, z.B. zu beschichten mit einer amorphen und/oder dotierten (z.B. n-dotierten) Vermittlerschicht 108r (dann auch als rückseitige Vermittlerschicht 108r bezeichnet), welche z.B. die Rückseitenpassivierung 106r (z.B. elektrisch und/oder physisch) kontaktiert.

Im späteren Verlauf kann die rückseitige Vermittlerschicht 108r optional mit elektrisch leitfähigen (z.B. ein Metall aufweisend oder zumindest metallischen) Material beschichtet werden, welche die rückseitige Vermittlerschicht 108r (elektrisch und/oder körperlich) kontaktiert. Das elektrisch leitfähige Material kann eine rückseitige Metallisierung 112 (auch als Rückseitenmetallisierung 112 bezeichnet) bilden (dann auch als Metallisieren bezeichnet). Das Metallisieren kann, muss aber nicht zwangsläufig im Vakuum erfolgen.

Die so beschichtete Rückseite 100r weist einen Schichtstapel 112, 114r, 108r, 106r (auch als passivierender Kontaktschichtstapel bezeichnet) auf, der die Rückseitenmetallisierung 112, eine optional darunter gebildete dielektrische Schicht 114r (beispielsweise als Lichteinkopplungsschicht bezeichnet, wie später noch genauer beschrieben wird), die darunter gebildete Vermittlerschicht 108r, und die darunter gebildete Rückseitenpassivierung 106r aufweist. Der Kontaktschichtstapel 112, 114r, 108r, 106r kann den passivierten Kontakt bilden oder zumindest Teil dessen sein, und wird, wenn die rückseitige Vermittlerschicht 108r eine Tunneloxidschicht ist, als rückseitiger Tunneloxid-passivierter Kontakt (TOPCon - "Tunnel Oxide Passivated Contact") bezeichnet. Der hier veranschaulichte rückseitige TOPCon kann als n-leitender passivierter Rückseitenkontakt (TOPCon) ausgebildet sein. Hierin wird zur Vereinfachung auch eine Vorstufe des passivierten Kontakts, z.B. ohne Metallisierung und/oder ohne Antireflexbeschichtung (beispielsweise auch als Lichteinkopplungsschicht bezeichnet), als TOPCon bezeichnet. Das für bezüglich des TOPCon Beschriebene kann in Analogie gelten für jeden passivierten Kontakt anderen Typs, der beispielsweise nicht unbedingt ein Tunneloxid aufweisen muss.

Das Bilden (z.B. dessen Metallisierung, z.B. die metallische Kontaktierung) eines einseitigen TOPCon, beispielsweise auf der Rückseite 100r, kann gitterförmig erfolgen und/oder durch ein Gitter (wie bei einem beidseitigen TOPCon) realisiert werden (dann auch als Gitter-TOPCon bezeichnet) und/oder muss nicht notwendigerweise ganzflächig erfolgen. Diesbezüglich ist darauf hinzuweisen, dass nicht der gesamte Kontaktschichtstapel der Gitter-TOPCon gitterförmig ausgebildet werden muss. Beispielsweise können zumindest die Passivierung und/oder die Vermittlerschicht (z.B. eine aSi/polySi-Schicht) und/oder die Lichteinkopplungsschicht des TOPCon auch ganzflächig ausgebildet werden. Alternativ oder zusätzlich kann die Vermittlerschicht (z.B. die aSi/polySi-Schicht) des TOPCon nur unterhalb der gitterförmigen Metallisierung ausgebildet werden, beispielsweise wenn der TOPCon auf der Vorderseite 100v angeordnet ist oder der Solarzellenpräkursor (bzw. die fertige Solarzelle) nur einseitig kontaktiert werden soll.

In einer exemplarischen Implementierung kann die aus aSi (z.B. n-dotiert) und/oder polySi (z.B. n-dotiert) bestehende Vermittlerschicht des TOPCon als Gitter ausgebildet sein oder werden. Beispielsweise kann die Vermittlerschicht nur unter den gitterförmigen Metallkontakten der Solarzelle ausgebildet sein oder werden. Die Passivierung des TopCon kann alternativ oder zusätzlich ganzflächig ausgebildet sein oder werden.

Der Solarzellenpräkursor weist optional eine (beispielsweise dielektrische und/oder transparente) Antireflexbeschichtung 114v auf der Vorderseite 100v (auch als vorderseitige Antireflexbeschichtung 114v bezeichnet) auf, welche eine oder mehr als eine Antireflexschicht aufweist (beispielsweise einen Stapel mehrerer Antireflexschichten). Die Dicke der vorderseitigen Antireflexbeschichtung 114v kann beispielsweise in einem Bereich sein von ungefähr 50 nm bis ungefähr 500 nm. Die vorderseitige Antireflexbeschichtung 114v kann beispielsweise einen Brechungsindex aufweisen von weniger als ungefähr 2,2, z.B. von weniger als ungefähr 1,5, z.B. von weniger als ungefähr 1,4. Die vorderseitige Antireflexbeschichtung 114v kann beispielsweise ein Dielektrikum aufweisen, z.B. ein Nitrid (z.B. ein Halbleiternitrid, z.B. Siliziumnitrid). Beispielsweise weist die Antireflexbeschichtung 114v Siliziumnitrit auf oder besteht daraus.

Der Solarzellenpräkursor (z.B. dessen Kontaktschichtstapel) weist optional eine (beispielsweise dielektrische und/oder transparente) Antireflexbeschichtung 114r auf der Rückseite 100r (auch als rückseitige Antireflexbeschichtung 114r bezeichnet) auf, welche eine oder mehr als eine Antireflexschicht aufweist (beispielsweise einen Stapel mehrerer Antireflexschichten). Die Dicke der rückseitigen Antireflexbeschichtung 114r kann beispielsweise in einem Bereich sein von ungefähr 50 nm bis ungefähr 500 nm. Die rückseitige Antireflexbeschichtung 114r kann beispielsweise einen Brechungsindex aufweisen von weniger als ungefähr 2,2, z.B. von weniger als ungefähr 1,5, z.B. von weniger als ungefähr 1,4. Die rückseitige Antireflexbeschichtung 114r kann beispielsweise angeordnet sein zwischen der Rückseitenmetallisierung 112 (insofern vorhanden) und der Rückseitenpassivierung 106r (insofern vorhanden), z.B. in physischem Kontakt mit der Vermittlerschicht 108r, und/oder der Rückseitenmetallisierung 112 (insofern vorhanden). Ist die rückseitige Antireflexbeschichtung 114r vorhanden und dielektrisch, kann auch der Stapel aus Rückseitenpassivierung 106r, Vermittlerschicht 108r (insofern vorhanden) und rückseitiger Antireflexbeschichtung 114r beispielsweise eine Rückseitenpassivierung bereitstellen oder zumindest einen Teil eines rückseitigen TOPCon Schichtstapels bereitstellen.

Die rückseitige Antireflexbeschichtung 114r kann beispielsweise ein Dielektrikum aufweisen, z.B. ein Nitrid (z.B. ein Halbleiternitrid, z.B. Siliziumnitrid). Beispielsweise weist die Antireflexbeschichtung 114r Siliziumnitrit auf oder besteht daraus. Beispielsweise kann die rückseitige Antireflexbeschichtung 114r zumindest SiNx:H aufweisen oder daraus bestehen.

Optional kann die rückseitige Antireflexbeschichtung 114r Wasserstoff aufweisen. Dies erreicht, dass aus der rückseitigen Antireflexbeschichtung 114r Wasserstoff zur Verfügung gestellt werden kann, der die Passivierungseigenschaften des TOPCon durch Reduktion der Rekombination freier Ladungsträger an der Grenzfläche verbessert, z.B. indem freie Bindungen an der Grenzfläche von Substrat 102 und Tunneloxid 106r abgesättigt werden.

Optional kann die vorderseitige Antireflexbeschichtung 114v, insofern vorhanden, eine oder mehr als eine Durchgangsöffnung aufweisen, wovon jede Durchgangsöffnung einen hochdotierten Abschnitt 1041 der Emitterschicht 104 (auch als lokaler Emitter 1041 bezeichnet) freilegt. Alternativ oder zusätzlich kann die oder jede Durchgangsöffnung der vorderseitigen Antireflexbeschichtung 114v mit einem elektrisch leitfähigen (z.B. ein Metall aufweisend oder zumindest metallischen) Material gefüllt sein, welche die Emitterschicht 104 (elektrisch und/oder körperlich) kontaktiert. Das elektrisch leitfähige Material kann Teil einer vorderseitigen Metallisierung 110 (auch als Vorderseitenmetallisierung 110 bezeichnet) sein und/oder zumindest aus der Antireflexbeschichtung 114v hervorstehen.

Die Emitterschicht 104 ist zwischen der Basisschicht 102 und der Vorderseitenmetallisierung 110, insofern vorhanden, und/oder der vorderseitigen Antireflexbeschichtung 114v, insofern vorhanden, angeordnet.

**Fig.2** veranschaulicht eine Solarzelle gemäß verschiedenen Ausführungsformen 200 in einem schematischen Aufbaudiagramm im Querschnitt, welche ähnlich zu den Ausführungsformen 100 ist, mit dem Unterschied, dass (alternativ oder zusätzlich zu der Rückseite 100r) die Vorderseite 100v passiviert ist (mittels der Vorderseitenpassivierung 106v) bzw. auf dieser ein TOPCon (oder zumindest ein Teil dessen) gebildet ist oder wird. Die Emitterschicht 104 ist zwischen der Vorderseitenpassivierung 106v und der Basisschicht 102 angeordnet.

Das Bearbeiten des Solarzellenpräkursors, der beispielsweise die passivierte Rückseite 100r aufweist, kann in diesem Fall aufweisen, eine amorphe und/oder dotierte (z.B. p-dotierte) Vermittlerschicht 108v auf der Vorderseitenpassivierung 106v zu bilden (dann auch als vorderseitige Vermittlerschicht 108v bezeichnet), welche z.B. die Vorderseitenpassivierung 106v (z.B. elektrisch und/oder physisch) kontaktiert.

Die Vorderseitenpassivierung 106v kann beispielsweise als Tunneloxidschicht ausgebildet sein. Dann kann diese beispielsweise eine Dicke aufweisen von weniger als ungefähr 5 Nanometer (nm), z.B. weniger als ungefähr 2 Nanometer (nm) und/oder in einem Bereich von ungefähr 1 nm bis ungefähr 2 nm.

Im späteren Verlauf kann die vorderseitige Vermittlerschicht 108v optional mit der vorderseitigen Antireflexbeschichtung 114v und/oder einem elektrisch leitfähigen (z.B. ein Metall aufweisend oder zumindest metallischen) Material beschichtet sein, welche die vorderseitige Vermittlerschicht 108v und/oder die vorderseitige Antireflexbeschichtung 114v (elektrisch und/oder körperlich) kontaktiert. Das elektrisch leitfähige Material kann die Vorderseitenmetallisierung 110 bilden. Die so gebildete vorderseitige Vermittlerschicht 108v kann zwischen der Emitterschicht 104 und der vorderseitigen Antireflexbeschichtung 114v, insofern vorhanden, und/oder der Vorderseitenmetallisierung 110, insofern vorhanden, angeordnet sein.

Optional kann die vorderseitige Antireflexbeschichtung 114v eine oder mehr als eine Durchgangsöffnung aufweisen, wovon jede Durchgangsöffnung einen Abschnitt der vorderseitigen Vermittlerschicht 108v freilegt. Alternativ oder zusätzlich kann die oder jede Durchgangsöffnung der vorderseitigen Antireflexbeschichtung 114v mit dem elektrisch leitfähigen (z.B. ein Metall aufweisend oder zumindest metallischen) Material der Vorderseitenmetallisierung 110 gefüllt sein, welche die Emitterschicht 104 beispielsweise (elektrisch und/oder körperlich) kontaktiert.

Die so beschichtete Vorderseite 100v weist einen Kontaktschichtstapel 110, 114v, 108v, 106v auf, der die Vorderseitenmetallisierung 110, die darunter gebildete Antireflexbeschichtung 114v, die darunter gebildete Vermittlerschicht 108v, und die darunter gebildete Vorderseitenpassivierung 106v aufweist. Der Kontaktschichtstapel 110, 114v, 108v, 106v wird auch als vorderseitiger Tunneloxid-passivierter Kontakt (TOPCon) bezeichnet, wenn die vorderseitige Vermittlerschicht 108v eine Tunneloxidschicht ist. Der hier veranschaulichte vorderseitige TOPCon kann als p-leitender passivierter Vorderseitenkontakt ausgebildet sein.

Im späteren Verlauf kann die rückseitige Vermittlerschicht 108r, insofern vorhanden, optional mit einer (beispielsweise dielektrischen) Antireflexbeschichtung 114r auf der Rückseite 100r (auch als rückseitige Antireflexbeschichtung 114r bezeichnet) beschichtet werden. Alternativ oder zusätzlich kann die rückseitige Vermittlerschicht 108r, insofern vorhanden, mit einem elektrisch leitfähigen (z.B. ein Metall aufweisend oder zumindest metallischen) Material beschichtet sein, welche die Vermittlerschicht 108r und/oder die Antireflexbeschichtung 114r (elektrisch und/oder körperlich) kontaktiert. Das elektrisch leitfähige Material kann die Rückseitenmetallisierung 112 bilden oder zumindest Teil dieser sein.

Die Rückseite 100r des Solarzellenpräkursor kann optional texturiert und/oder strukturiert sein (nicht dargestellt). Dies verbessert die Lichtaufnahme.

Nachfolgend wird auf das Bearbeiten derjenigen Seite des Solarzellenpräkursors (auch als passivierte Seite bezeichnet) Bezug genommen, welche jeweils passiviert ist. Beispiele für die passivierte Seite weisen auf: die mit der Rückseitenpassivierung 106r beschichteten Rückseite 100r des Solarzellenpräkursors; und/oder die mit der Vorderseitenpassivierung 106v beschichteten Vorderseite 100v des Solarzellenpräkursors. Das für die passivierte Seite beschriebene Bearbeiten kann in Analogie gelten für die passivierte Rückseite 100r, die passivierte Vorderseite 100v oder die (vorzugsweise nacheinander) Bearbeitung beider passivierten Seiten. Es können beispielsweise beide Seiten in derselben Prozesskammer (z.B. auch gleichzeitig von oben und unten) beschichtet werden.

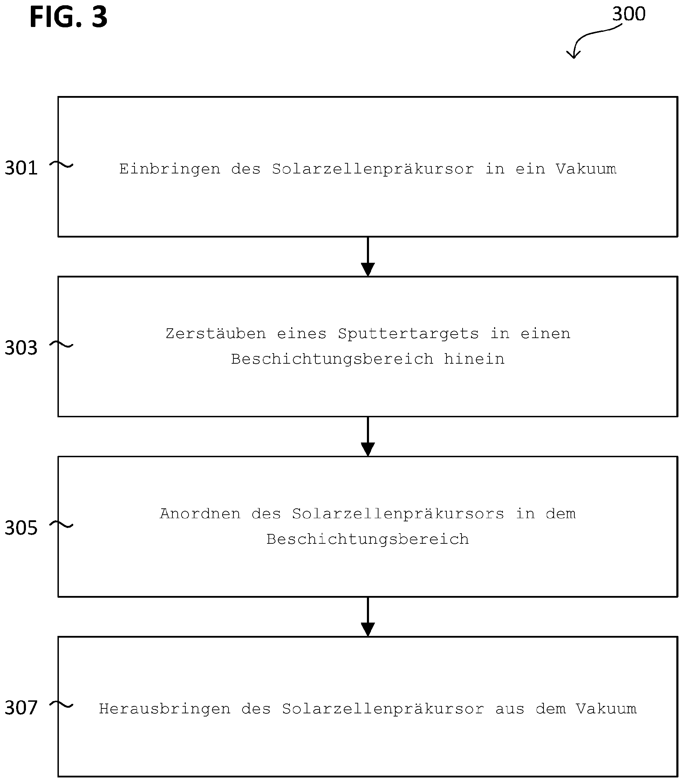

**Fig.3** veranschaulicht ein Verfahren 300 gemäß verschiedenen Ausführungsformen in einem schematischen Ablaufdiagramm. Das Verfahren 300 weist auf, in 303, Zerstäuben eines Sputtertargets in einen Beschichtungsbereich (in dem beispielsweise ein Vakuum gebildet ist) hinein; und in 305; Anordnen des Solarzellenpräkursors in dem Beschichtungsbereich, wobei die passivierte Seite des Solarzellenpräkursors dem Sputtertarget zugewandt ist. Das Verfahren 300 weist optional auf, in 301, Einbringen des Solarzellenpräkursor in das Vakuum, das in dem Beschichtungsbereich gebildet ist; und in 303, Herausbringen des Solarzellenpräkursor aus dem Vakuum, das in dem Beschichtungsbereich gebildet ist.

Beispielsweise kann der Solarzellenpräkursor, wenn dieser in dem Beschichtungsbereich angeordnet ist und/oder wenn das Sputtertarget in den Beschichtungsbereich hinein zerstäubt wird, in einem Substratträger, z.B. in einer Vertiefung (auch als Substrataufnahmetasche bezeichnet) davon, angeordnet sein, wie später noch genauer erläutert wird.

Beispielsweise kann der Solarzellenpräkursor, wenn dieser in dem Beschichtungsbereich angeordnet ist und/oder das Sputtertarget in den Beschichtungsbereich hinein zerstäubt wird, eine Temperatur (auch als Beschichtungstemperatur bezeichnet) aufweisen von weniger als ungefähr 200°C, vorzugsweise weniger als ungefähr 100°C, und/oder von weniger als einer Temperatur des Sputtertargets aufweisen. Dies begünstigt bessere Schichteigenschaften, z.B. der (z.B. vorderseitigen oder rückseitigen) Vermittlerschicht, spart Energie, hemmt die Entstehung giftiger flüchtiger Stoffe und/oder hemmt das Abplatzen der Vermittlerschicht. Beispielsweise kann der Solarzellenpräkursor, wenn dieser in dem Beschichtungsbereich angeordnet ist und/oder das Sputtertarget in den Beschichtungsbereich hinein zerstäubt wird, ungeheizt sein (abgesehen von dem thermischen Eintrag durch das Sputtern selbst).

Beispielsweise kann das Sputtertarget ein Halbleitermaterial (z.B. das der Basisschicht 102 und/oder das der Rückseitenpassivierung 106r aufweisen) und einen Dotanten (z.B. einen n-Dotanten) des Halbleitermaterials (z.B. als binäres und/oder homogenes Gemisch). Das Sputtertarget kann ein sogenanntes hochdotiertes Sputtertarget sein. Das hochdotierte Sputtertarget kann eine Menge des Dotanten (z.B. im Verhältnis zu dem Halbleitermaterial) aufweisen, das größer ist als eine Löslichkeitsgrenze SG des Dotanten in dem Halbleitermaterial (dann auch als hochdotiertes Target bezeichnet) und/oder größer ist als 0,15 gew% (beispielsweise wenn der Dotant Phosphor ist und das Halbleitermaterial Silizium ist (beispielsweise entsprechen 0,15gew% P in Si ungefähr 0,14at% bzw. 7e19at/cm³)).

Das mittels des Sputtertargets gebildete Plasma bzw. die daraus gebildete Schicht (z.B. Vermittlerschicht) kann eine ähnliche chemische Zusammensetzung aufweisen, wie das Sputtertarget, z.B. im Wesentlichen dasselbe Mengenverhältnis des Dotanten zu dem Halbleitermaterial wie das Sputtertarget.

Anschaulich wurde erkannt, dass das beim Sputtern verwendete Target (auch als Sputtertarget bezeichnet) zwar kostengünstig aus der Schmelze hergestellt werden (auch als Gusstarget bezeichnet) kann, dieses Herstellungsverfahren allerdings engen Grenzen bei der Materialauswahl unterworfen ist. Soll das Targetmaterial ein festes und homogenes Gemisch aufweisen, kann dieses eine Löslichkeitsgrenze SG aufweisen, oberhalb welcher sich das Gemisch entmischt, was beispielsweise ein heterogenes Gemisch zur Folge hat. Die Entmischung kann zur Bildung von Ausscheidungen führen und so eine ungleichmäßige chemische Zusammensetzung des Targets zur Folge haben. Ein Beispiel für diese Löslichkeitsgrenze SG ist ein Targetmaterial, das aus gegossenem Silizium (Si) bestehen soll, in welchem Phosphor gelöst ist. Die mittels kommerzieller Verfahren hergestellte und am Markt erhältlichen höchsten Dotierkonzentrationen Dmax von Phosphor (P) in Festkörpern aus Silizium liegt bei ungefähr 0,15 at% P in Si (entspricht ungefähr 7.10¹⁹at/cm³) oder weniger. Soll die Löslichkeit des P in Si größer als 0,15 at% sein, kann auf diese kostengünstige Herstellung nicht zurückgegriffen werden. Das Target wird dann gemäß verschiedenen Ausführungsformen mittels Spritzens und/oder Sinterns hergestellt.

Gemäß verschiedenen Ausführungsformen wird das Sputtern (auch als Zerstäuben mittels eines Plasmas bezeichnet) eines homogenen Silizium/Phosphorgemischs mit einem Phosphoranteil von mehr als 0.5at% Phosphor erleichtert. Gemäß verschiedenen Ausführungsformen wird als Ergebnis des Sputterns des Silizium/Phosphorgemischs eine amorphe phosphordotierte Siliziumschicht (auch als aSiP-Schicht bezeichnet) als Vermittlerschicht erhalten. Die so gebildete Vermittlerschicht kann, beispielsweise nach der Weiterverarbeitung in einem Hochtemperaturschritt (bspw. bei Temperaturen >900C >850C oder >800C für bspw. 1-5 min >5min >15min) beispielsweise in einem Rohrofen zur Kristallisation der abgeschiedenen Schicht und gleichzeitiger elektrischer Aktivierung (z.B. durch Einbau des Dotanten in das Si-Kristallgitter) des Dotanten, besonders gute Eigenschaften aufweisen, z.B. einen Flächenwiderstand von weniger als 1000 (oder 200) Ohm (auch als Schichtwiderstand von 1000 Ohm/sq bezeichnet) aufweisen und/oder eine (beispielsweise elektrisch aktive) Konzentration (auch als Dotierstoffkonzentration bezeichnet) des (z.B. aktiven) Dotanten (z.B. Phosphor), die größer ist als 7·10¹⁹ at/cm³, vorzugsweise als >1·10²⁰ at/cm³. Die Dotierstoffkonzentration kann auf denjenigen Anteil des Dotanten bezogen sein, der auch aktiv ist (auch als aktiver Dotant bezeichnet), z.B. in das Kristallgitter eingebaut ist. Optional kann die Vermittlerschicht vor der Aktivierung des Dotanten durch den Hochtemperaturschritt eine Gesamtkonzentration von >7·10¹⁹ at/cm³ (zum Beispiel >5·10²⁰ at/cm³ oder >1·10^{2 1} at/cm³, oder z.B. 5·10²⁰ at/cm³) des Dotanten aufweisen, der unmittelbar nach der Beschichtung überwiegend inaktiv ist (auch als inaktiver Dotant bezeichnet). Die nach der Aktivierung des Dotanten verbleibende Konzentration (auch als Reservekonzentration bezeichnet) an inaktiven Dotanten ist beispielsweise größer oder kleiner als die Dotierstoffkonzentration (z.B. nach Durchführung des Hochtemperaturschritts). Ist die Reservekonzentration größer als null (z.B. >1·10²⁰ at/cm³) kann dies begünstigen, dass metallische Verunreinigungen gebunden (auch als Gettern bezeichnet) werden. Beispielsweise kann das Bilden der Vermittlerschicht derart erfolgen, dass diese mehr Korngrenzen aufweist als die Rückseitenpassivierung 106r, und/oder die Antireflexbeschichtung 114r. Beispielsweise können mittels PVD durch die im Vergleich zu anderen CVD-gestützten Verfahren (wie z.B. LPCVD, PECVD) zwei bis zehn mal kleineren Kristallkörner (Durchmesser D ca. 10-50nm im Vgl. zu D >100nm Durchmesser) der poly-Si Schicht derart viele Korngrenzen eingebracht werden, die es erlauben Phosphor und metallische Verunreinigungen (aus Target oder Wafer oder Prozess) zu gettern, beispielsweise lokal in der poly-Si Schicht zu binden/fixieren, so dass gehemmt wird, dass diese in nachfolgenden Prozessschritten zu einer Erniedrigung des Solarzellenwirkungsgrades beitragen durch Kontamination der Basisschicht 102 mit eben diesen metallischen Verunreinigungen aus der Gesamtprozesskette.

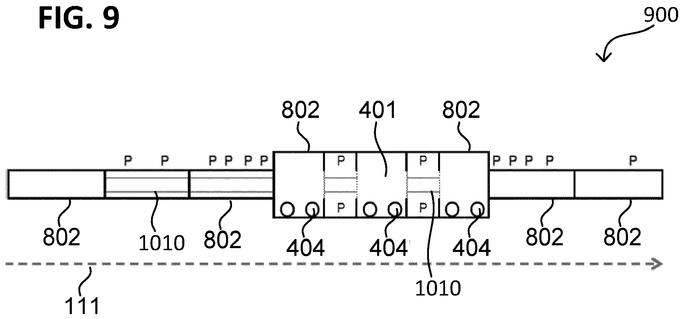

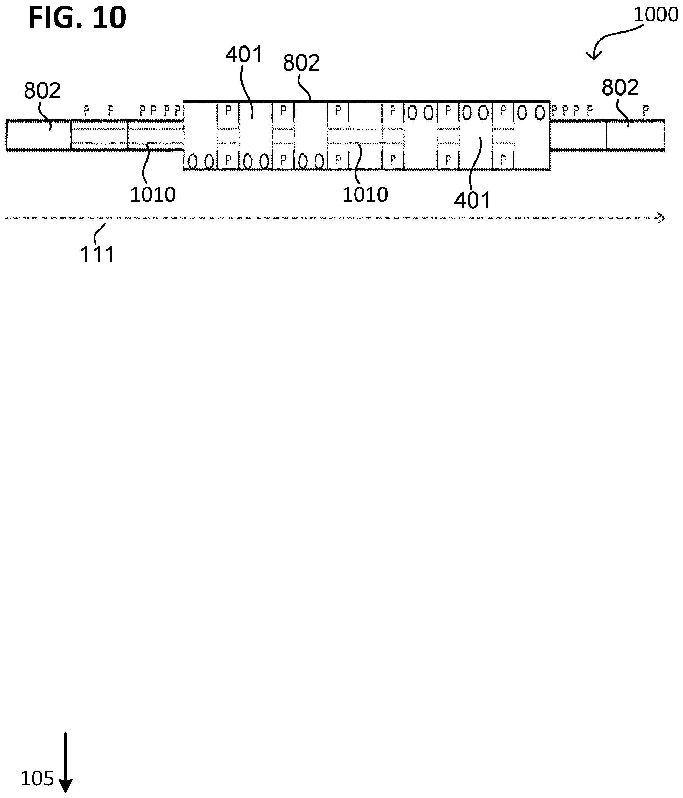

Optional kann der Solarzellenpräkursor vor dem Transport in den Beschichtungsbereich hinein und/oder nach dem Transport aus dem Beschichtungsbereich heraus erwärmt werden, beispielsweise im Vakuum (z.B. der Vakuumanordnung) und/oder mittels einer Heizvorrichtung 1010 (siehe Fig.9 und 10). Beispielsweise kann der Solarzellenpräkursor beim Transport in den Beschichtungsbereich hinein abkühlen.

Die passivierte Seite kann gebildet werden, indem der Solarzellenpräkursor auf der Seite mit der Passivierung (z.B. Vorderseitenpassivierung 106v oder Rückseitenpassivierung 106r) beschichtet wird (auch als Passivierungsprozess bezeichnet). Der Passivierungsprozess kann erfolgen, bevor der Solarzellenpräkursor in den Beschichtungsbereich hinein transportiert wird, beispielsweise bevor dieser in die Vakuumanordnung (z.B. in das darin bereitgestellte Vakuum) eingeschleust wird.

Beispielsweise kann der Passivierungsprozess aufweisen, die Passivierung (z.B. eine Tunneloxidschicht und/oder Siliziumoxid aufweisend) zu bilden mittels eines nasschemischen Prozesses, mittels eines plasmaunterstützten Prozesses im Vakuum (z.B. PECVD, LPCVD, PVD, ALD usw.), und/oder mittels thermischer Reaktion (z.B. Oxidation). Die thermische Reaktion kann aufweisen, die zu passivierende Seite des Solarzellenpräkursors einem Reaktivgas (z.B. Sauerstoff oder auch Ozon) auszusetzen, wenn dieses auf oder über eine Temperatur (auch als Reaktionstemperatur bezeichnet) gebracht ist, bei der die zu passivierende Seite des Solarzellenpräkursors mit dem Reaktivgas reagiert (z.B. über 300°C). Die thermische Reaktion kann alternativ oder zusätzlich in einem Rohrofen erfolgen.

Optional kann das Verfahren 300 eines oder mehr als eines von Folgendem aufweisen:
- dass die gebildete Vermittlerschicht (z.B. Silizium-Dünnschicht) n-dotiert ist mit einer Dotierstoffkonzentration (z.B. bei Phosphor als Dotant) von mehr als ungefähr 7·10¹⁹ at/cm³, bevorzugt mehr als ungefähr 1·10²⁰ at/cm³, beispielsweise bezogen auf das Halbleitermaterial (z.B. Silizium). Diese Dotierstoffkonzentration entspricht ungefähr einem Massenanteil (auch in gew% angegeben) des Dotanten von 0,15% (bei 7·10¹⁹ at/cm³) bzw. 0,22% (bei 1·10²⁰ at/cm³), beispielsweise bezogen auf das Halbleitermaterial (z.B. Silizium);
- dass der Dotant (auch als Dotierstoff bezeichnet) aus mindestens einem homogenen Festkörper (z.B. einem Si/Dotierstoff-Target) bereitgestellt wird;
- dass keine Dotierung der Vermittlerschicht aus der molekularen Gasphase, mittels eines Mosaiktargets, mittels Zerstäubens eines Targets aus dem Dotierstoff (das sogenannten intermediate Sputtern) und/oder mittels einer Dotierstoffpaste erfolgt;
- dass der Solarzellenpräkursor, beispielsweise beim Bilden der Vermittlerschicht, keinem Gas ausgesetzt ist, das molekular ist und/oder Wasserstoff aufweist, z.B. keinem Gas ausgesetzt ist, das SiH₄ und/oder PH₃ aufweist oder dem SiH₄ und/oder PH₃ zugeführt wird;
- dass die Vermittlerschicht (z.B. Siliziumdünnschicht) ausschließlich auf der passivierten Seite abgeschieden wird;
- dass die Vermittlerschicht (z.B. Siliziumdünnschicht) einen Abstand von einer der passivierten Seite, die dem Sputtertarget zugewandt ist, gegenüberliegende Seite des Solarzellenpräkursor aufweist, bzw. diese (elektrisch und/oder physisch) nicht kontaktiert;
- die innerhalb des Beschichtungsbereichs gebildete Vermittlerschicht (z.B. Siliziumdünnschicht) unverändert verbleibt bis zur Klassifizierung der Solarzelle und/oder kein Rückätzen der Vermittlerschicht erfolgt.

Anschaulich ermöglicht der Umstand, dass die Vermittlerschicht mittels Sputterns gebildet wird, (im Vergleich zu CVD) eine geringere Beschichtungstemperatur und/oder weniger Wasserstoff, dem der Solarzellenpräkursor ausgesetzt ist. Die Abwesenheit von Wasserstoff trägt dazu bei, das sogenannte Blistering zu vermeiden, das ein lokales Abplatzen der Vermittlerschicht durch die Bildung von Gasbläschen (z.B WasserstoffBläschen) bezeichnet. Ein zusätzliches Heizen des Substrates auf hohe Temperaturen über 300C z.B. auf circa 350C oder >400C ist somit nicht notwendig um das Risiko des Blisterings herabzusetzen, was technisch deutlich weniger aufwändig ist und die Materialauswahl z.B. für die Substratträger vereinfacht. Dies bietet die Möglichkeit, den Solarzellenpräkursor ungeheizt oder nur gering geheizt (ca. 100-200°C, oder bei zumindest weniger als 300°C) mit der Vermittlerschicht zu beschichten, ohne das Risiko des Blisterings in Kauf nehmen zu müssen (beispielsweise im Vergleich zur Verwendung von PH₃ als Dotiergas).

Alternativ oder zusätzlich kann die Vermittlerschicht mehrere (zum Beispiel zwei oder mehr) Einzelschichten aufweisen, die sich in ihrer Dotierkonzentration voneinander unterscheiden.

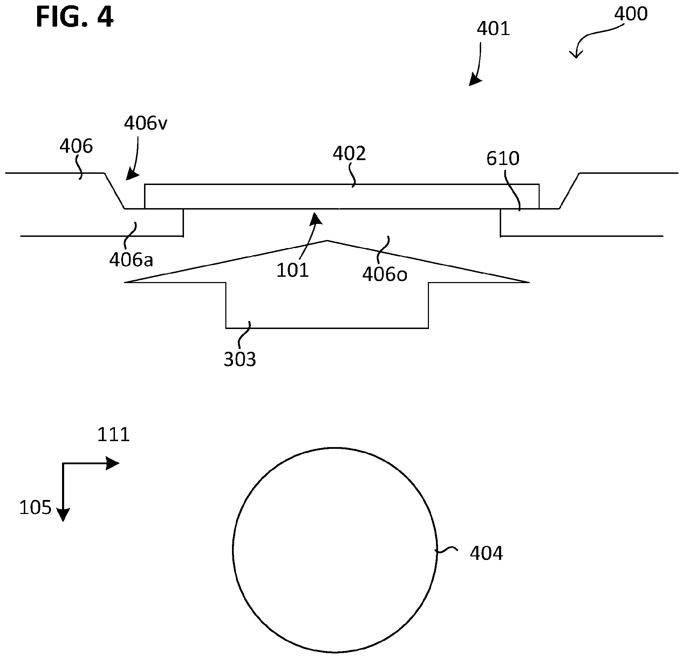

**Fig.4** veranschaulicht eine Vakuumanordnung in Sputter-Up-Konfiguration (auch als Aufwärtssputtern-Konfiguration bezeichnet) gemäß verschiedenen Ausführungsformen 400 in einer schematischen Querschnittsansicht (mit Blick quer zur Transportrichtung 111). Gemäß der Sputter-Up-Konfiguration ist das Sputtertarget 404 unterhalb eines Transportpfads angeordnet, entlang dessen der Solarzellenpräkursor 402 in dem Beschichtungsbereich 401 transportiert wird.

Wie vorstehend beschrieben, kann der Solarzellenpräkursor 402, wenn dieser in dem Beschichtungsbereich 401 angeordnet ist und/oder wenn das Sputtertarget 404 in den Beschichtungsbereich 401 hinein zerstäubt 303 wird, mittels eines Substratträgers 406 transportiert werden. Der Substratträger 406 kann eine Substrataufnahmetasche 406v aufweisen, in welcher der Solarzellenpräkursor 402 angeordnet ist.

Der Substratträger 406 kann, pro Substrataufnahmetasche 406v, eine (z.B. rahmenförmige) Substratauflage 406a aufweisen, welche die Substrataufnahmetasche 406v (z.B. in Richtung der Gravitationsrichtung 105) begrenzt. Die Substratauflage 406a kann von einer Öffnung 406o (auch als Beschichtungsöffnung 406o bezeichnet) durchdrungen sein, welche die passivierte Seite (die Vorderseite oder Rückseite) des Solarzellenpräkursor 402 freilegt gegenüber dem Sputtertarget 404.

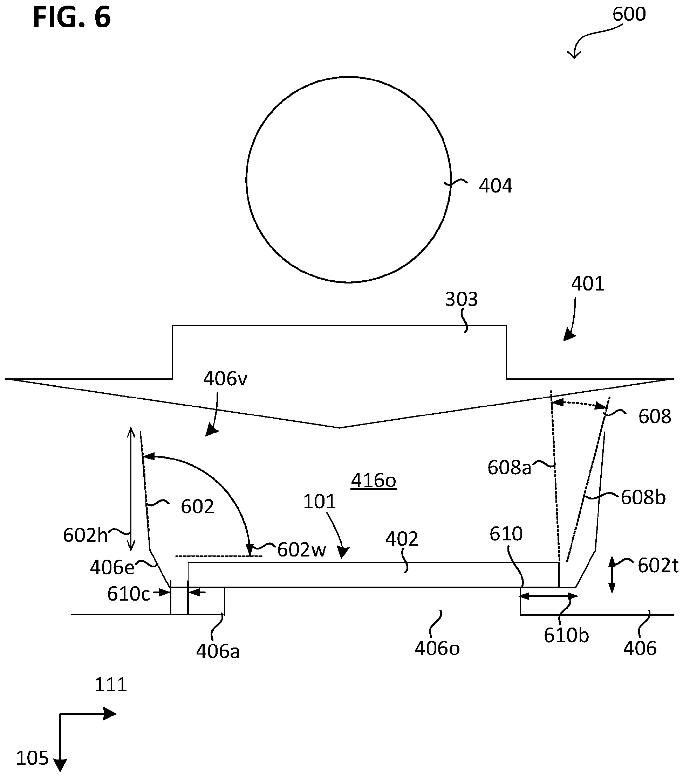

Die Substratauflage 406a weist beispielsweise eine planare Auflagefläche 610 auf, welche die Beschichtungsöffnung 406o umgibt und auf welcher der Solarzellenpräkursor 402 aufliegen kann. Die Breite 610b (siehe auch Fig.6) der Auflagefläche 610 (auch als Auflagebreite bezeichnet) kann beispielsweise größer sein als ungefähr 0,5 mm (Millimeter), z.B. als ungefähr 1 mm, z.B. als ungefähr 2 mm, z.B. als ungefähr 3 mm.

Die Substratauflage 406a (z.B. deren Auflagefläche 610) kann die Beschichtungsöffnung 406o zusammenhängend umlaufen (d.h. entlang eines in sich geschlossenen Pfades verlaufen). Dies hemmt, dass der Rand des Solarzellenpräkursor 402 (bzw. die daran angrenzende Seitenfläche und/oder Kante) beschichtet wird. Die Substratauflage 406a stellt anschaulich eine Verschattungsmaske bereit, welche den Rand des Solarzellenpräkursor 402 abschattet vor dem Beschichtungsmaterial, das von unten in den Beschichtungsbereich 401 hinein zerstäubt 303 wird.

Das in den Beschichtungsbereich 401 hinein zerstäubte 303 Beschichtungsmaterial kann Atomkerne des Halbleitermaterials (z.B. Si) und des Dotanten (z.B. P) aufweisen, beispielsweise in einem Massenverhältnis der Atomkerne des Dotanten zu den Atomkernen des Halbleitermaterials von mehr als 0,15 %.

Es kann verstanden werden, dass (z.B. alternativ oder zusätzlich zu der als Verschattungsmaske ausgebildeten Substratauflage 406a) auch eine lose Verschattungsmaske verwendet werden kann, die beispielsweise zwischen der Substratauflage 406a und dem Solarzellenpräkursor 402 angeordnet werden kann.

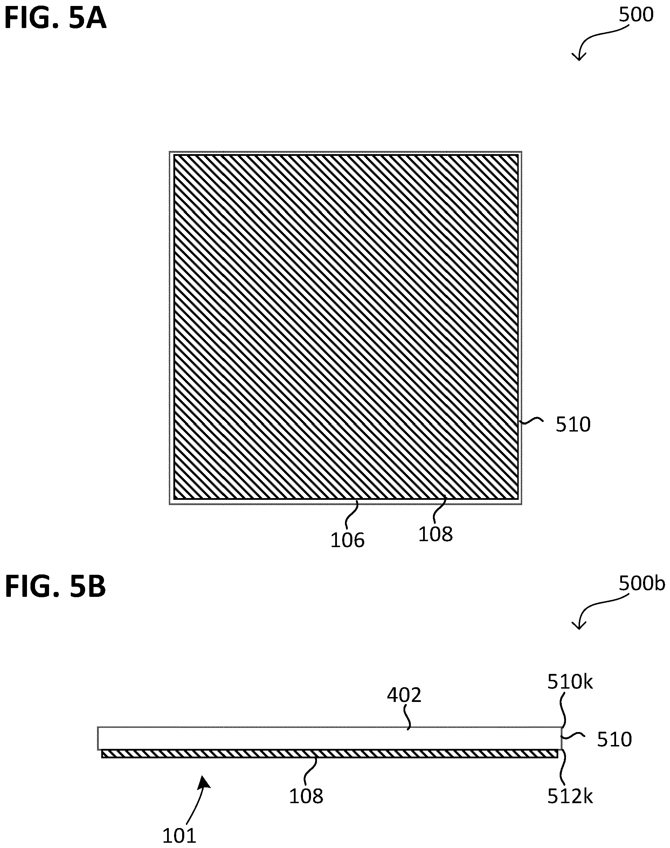

**Fig.5A** veranschaulicht den Solarzellenpräkursor 402 gemäß verschiedenen Ausführungsformen 500 in einer schematischen Draufsicht (auf die bearbeitete Seite) und **Fig.5B** in einer schematischen Querschnittsansicht 500b. Die mittels des Sputterns gebildete Vermittlerschicht 108 kann beispielsweise die rückseitige Vermittlerschicht 108r oder die vorderseitige Vermittlerschicht 108v sein.

Wie dargestellt, kann die Vermittlerschicht 108 einen Abstand von einer oder mehr als einer umlaufenden Kante 510k, 512k bzw. daran angrenzenden Seitenwand 510 des Solarzellenpräkursor 402 (auch als Präkursorseitenwand 510 bezeichnet) aufweisen, beispielsweise von mehr als ungefähr 0,5 mm (Millimeter), z.B. mehr als ungefähr 1 mm, z.B. mehr als ungefähr 2 mm, z.B. mehr als ungefähr 3 mm. Dies erreicht, dass die oder jede umlaufende Kante 510k, 512k bzw. Seitenwand 510 des Solarzellenpräkursor 402 frei ist von der Vermittlerschicht 108 und die Passivierung 106 (die Vorderseitenpassivierung 106v bzw. Rückseitenpassivierung 106r) freiliegend hervorstehen kann von der Vermittlerschicht 108.

Beispielsweise kann ein freiliegender Rand der Passivierung 106 (auch als Randausschluss bezeichnet) die Vermittlerschicht 108 zusammenhängend umlaufen. Die Vermittlerschicht 108 kann beispielsweise eine amorphe Siliziumschicht (dann auch als aSi-Schicht bezeichnet) sein.

Die umlaufende Kante bzw. Seitenwand 510 des Solarzellenpräkursors 402 können an die Passivierung 106 (z.B. den Randausschluss) angrenzen oder von ihr bedeckt sein. Beispielsweise kann das Oxid bzw. die Passivierung einen Randumgriff aufweisen.

**Fig.6** veranschaulicht eine Vakuumanordnung in Sputter-Down-Konfiguration (auch als Abwärtssputtern-Konfiguration bezeichnet) gemäß verschiedenen Ausführungsformen 600 in einer schematischen Querschnittsansicht (mit Blick quer zur Transportrichtung 111). Gemäß der Sputter-Down-Konfiguration ist das Sputtertarget 404 oberhalb eines Transportpfads angeordnet, entlang dessen der Solarzellenpräkursor 402 transportiert wird. Die Transportrichtung 111 kann beispielsweise senkrecht zu der Gravitationsrichtung 105 sein.

Wie vorstehend beschrieben, kann der Solarzellenpräkursor 402, wenn dieser in dem Beschichtungsbereich 401 angeordnet ist und/oder wenn das Sputtertarget 404 in den Beschichtungsbereich 401 hinein zerstäubt 303 wird, mittels des Substratträgers 406 transportiert werden. Der Substratträger 406 kann eine Substrataufnahmetasche 406v aufweisen, in welcher der Solarzellenpräkursor 402 angeordnet ist.

Der Substratträger 406 kann, pro Substrataufnahmetasche 406v, eine (z.B. rahmenförmige) Seitenwand 602 (auch als Taschenwand bezeichnet) aufweisen, welche die Substrataufnahmetasche 406v umlaufend begrenzt. Die Substrataufnahmetasche 406v kann eine Öffnung 416o (dann auch als obere Beschichtungsöffnung 416o bezeichnet) aufweisen, welche die passivierte Seite (die Vorderseite oder Rückseite) des Solarzellenpräkursor 402 freilegt gegenüber dem Sputtertarget 404.

Die Taschenwand 602 (z.B. deren Rand) kann die obere Beschichtungsöffnung 416o zusammenhängend umlaufen. Dies hemmt, dass die (anschaulich untere) Kante des Solarzellenpräkursor 402 (bzw. die daran angrenzende Seitenfläche), welche der passivierten Seite gegenüberliegt, beschichtet wird. Dazu kann die geometrische Ausdehnung der Substrataufnahmetasche 406v (auch als Pocket bezeichnet) bzw. der Taschenwand 602 an den Solarzellenpräkursor 402 angepasst sein.

Beispielsweise kann die Taschenwand 602 eine Höhe 602h (auch als Wandhöhe 602h bezeichnet) aufweisen und sich optional in Richtung zu der Substratauflage 406a hin verjüngen. Die Höhe ist in diesem Beispiel gemessen vom Scheitelpunkt des Flankenwinkels 602w bis zur Oberkante der Taschenwand 602 und ist somit größer als die Tiefe der Substrataufnahmetasche 406v (auch als Pockettiefe 602t bezeichnet), die gemessen wird vom Scheitelpunkt des Winkels 602w in Richtung 105 bis zur Auflagefläche 610 der Substratauflage 406a.

Ein Winkel 602w der Verjüngung (auch als Flankenwinkel bezeichnet) kann beispielsweise kleiner sein als 160°, beispielsweise als 130°. Die Höhe 602h und/oder die Pockettiefe können beispielsweise größer sein als 1mm, beispielsweise als 3mm. Die Höhe 602h und/oder die Pockettiefe können beispielsweise größer sein als das t-fache des Abstands 610c zwischen Substrat 402 und der umlaufenden Einlegeecke 406e des Substratträgers 406(in Transportrichtung 111 gemessen), wobei t größer sein kann als ungefähr 1, als ungefähr 3, als ungefähr 5 (für die Pockettiefe 602t), oder als ungefähr 2, oder als ungefähr 5, oder als ungefähr 10 (für die Höhe 602h), und/oder wobei t in einem Bereich sein kann von ungefähr 0,5 bis ungefähr 10.

Allgemeiner gesprochen kann der Substratträger eingerichtet sein, eine oder mehr als eine umlaufende Kante (an welche die Seitenwand angrenzt) des Solarzellenpräkursors 402 gegenüber dem Sputtertarget 404 zumindest teilweise abzuschatten. Dies kann begünstigt werden, wenn ein Winkel 608 (auch als Abschattungswinkel 608 bezeichnet), wie folgt bereitgestellt wird. Der Scheitel des Abschattungswinkels 608 kann auf der (anschaulich oberen) Kante der Seitenwand liegen, die dem Sputtertarget 404 zugewandt ist. Der Abschattungswinkel 608 kann in der von der Transportrichtung 111 und der Gravitationsrichtung 105 aufgespannten Ebene liegen.

Eine erste Sehne 608a des Abschattungswinkels 608 kann eine oder mehr als eine der folgenden Bedingungen erfüllen: die Seitenwand linear fortsetzen (d.h. in Verlängerung parallel zu der Seitenwand verlaufen); senkrecht zu der Transportrichtung 111 sein und/oder parallel zu der Gravitationsrichtung 105 sein.

Eine zweite Sehne 608b des Abschattungswinkels 608 kann eine oder mehr als eine der folgenden Bedingungen erfüllen: die Taschenwand 602 tangieren (z.B. nicht schneiden), einen Abschnitt der Taschenwand 602, welcher die Substrataufnahmetasche 406v in die Transportrichtung 111 begrenzt, berühren. Der Abschnitt der Taschenwand 602, welcher die zweite Sehne 608b berührt, kann beispielsweise auf einer Kante der Taschenwand 602 angeordnet sein, welche dem Sputtertarget 404 zugewandt ist.

Der Abschattungswinkel 608 kann beispielsweise kleiner sein als ungefähr 45°, z.B. als ungefähr 30°, z.B. als ungefähr 20°, z.B. als ungefähr 10°.

Anschaulich wirkt die umlaufende Taschenwand 602 als Verschattungsmaske, welche die obere Beschichtungsöffnung 416o aufweist. Es kann verstanden werden, dass (z.B. alternativ oder zusätzlich zu der als Verschattungsmaske ausgebildeten Substratauflage 406a) auch eine lose Verschattungsmaske verwendet werden kann, die beispielsweise zwischen der Substratauflage 406a und dem Solarzellenpräkursor 402 angeordnet werden kann.

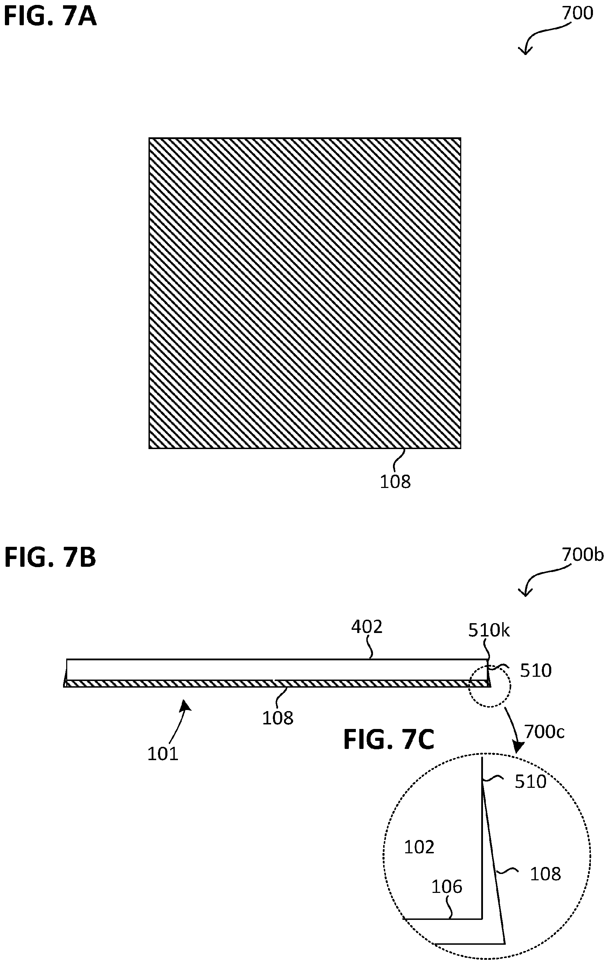

**Fig.7A** veranschaulicht den Solarzellenpräkursor 402 gemäß verschiedenen Ausführungsformen 700 in einer schematischen Draufsicht (auf die bearbeitete Seite), **Fig.7B** in einer schematischen Querschnittsansicht 700b, und **Fig.7C** in einer Detailansicht 700c. Die mittels des Sputterns gebildete Vermittlerschicht 108 kann beispielsweise die rückseitige Vermittlerschicht 108r oder die vorderseitige Vermittlerschicht 108v sein. Die Vermittlerschicht 108 kann beispielsweise eine amorphe Siliziumschicht (dann auch als aSi-Schicht bezeichnet) sein.

Wie dargestellt, kann die Vermittlerschicht 108 einen Abstand von der umlaufenden Kante 510k des Solarzellenpräkursors 402 aufweisen, welche der passivierten Seite 101 des Solarzellenpräkursors gegenüberliegt bzw. dem Target abgewandt war. Der Abstand kann beispielsweise größer sein als ungefähr ein Viertel der Substratdicke (übliche Solarzellenwafer aus Silizium weisen eine Dicke von ungefähr 200µm auf) z.B. ungefähr 50µm, z.B. größer als ungefähr 0,1 mm, z.B. bei Abschattung auch des Randbereichs der passivierten Seite 101 größer als ungefähr 0,5 mm, z.B. größer als ungefähr 1 mm. Dies erreicht, dass die Präkursorseitenwand 510 nur teilweise oder gar nicht von der Vermittlerschicht 108 bedeckt ist. Dann kann ein zusammenhängend umlaufender Abschnitt der Präkursorseitenwand 510, der neben der Vermittlerschicht 108 angeordnet ist, frei sein von der Vermittlerschicht 108.

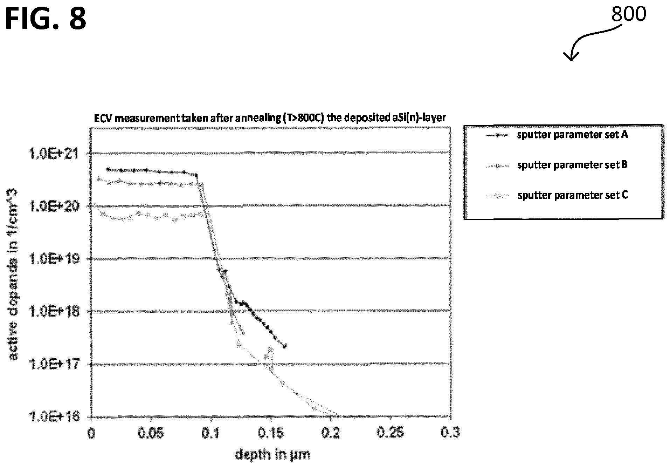

**Fig.8** veranschaulicht ein Arbeitsergebnis gemäß verschiedenen Ausführungsformen 800 in einem schematischen Diagramm, welches den Verlauf der Konzentration des elektrisch aktiven Phosphors über die Schichtdicke der mit Hilfe von Sputtern gebildeten (z.B. polykristallinen) Siliziumschicht als exemplarische Vermittlerschicht zeigt, beispielsweise nach dem Durchführen des Hochtemperaturschritts zur Kristallisation und Dotierung. Ein Arbeitsbeispiel des Hochtemperaturschritts erfolgte in einem Rohrofen bei mehr als 800°C für ungefähr 10 Minuten als Arbeitsbeispiel. Diesbezüglich wird Bezug genommen auf das Beschichtungsmaterial. Das Sputtertarget und/oder die mittels des Sputtertargets gebildete Vermittlerschicht kann das Beschichtungsmaterial aufweisen oder im Wesentlichen daraus bestehen. Die Siliziumschicht kann unmittelbar nach ihrer Bildung (z.B. Großteils) amorph sein und erst mittels des Kristallisationsprozesses (z.B. oberhalb von 800°C) zumindest teilweise (z.B. Großteils) in eine polykristalline Siliziumschicht überführt werden (auch als Kristallisieren bezeichnet).

In einer exemplarischen Implementierung kann das Beschichtungsmaterial eine Dotierstoffkonzentration (auch als Konzentration des Dotanten bezeichnet) aufweisen von mehr als ungefähr 7·10¹⁹ at/cm³ (Atome pro Kubikzentimeter), beispielsweise als ungefähr 1·10²⁰ at/cm³, beispielsweise als ungefähr 3·10²⁰ at/cm³. Dies mindert die Kosten, da die Vermittlerschicht nicht notwendigerweise nachträglich dotiert, z.B. durch einen extra Prozessschritt, werden muss, samt der oben genannten Risiken, diese dabei zu beeinträchtigen. Selbstverständlich kann die Vermittlerschicht alternativ oder zusätzlich auch einem Gas (beispielsweise Phosphan, vorzugsweise Phosphin, aufweisend) ausgesetzt werden, das den Dotant aufweist, und auf eine Temperatur (beispielsweise 200°C oder mehr) gebracht werden, bei der der Dotant aus dem Gas in die Vermittlerschicht eingebracht wird (auch als Gasphasendotierung bezeichnet), insofern dass gewünscht wird.

In einer exemplarischen Implementierung kann der Dotant des Beschichtungsmaterials vom n-Typ sein und/oder Phosphor aufweisen oder sein. Dies mindert die Kosten, da die benötigten Materialien sehr verbreitet sind.

Gemäß verschiedenen bevorzugten Ausführungsformen wird die Vermittlerschicht auf der passivierten Seite 101 gebildet mittels PVD (vorzugsweise Sputtern) und ohne Gasphasendotierung derart, dass der Dotant (z.B. vom n-Typ), vorzugsweise Phosphor aufweisend oder daraus bestehend, mittels eines Festkörpers bereitgestellt wird, z.B. mittels des Sputtertargets. Dieser Festkörper kann beispielsweise als planares Target oder als rohrförmiges Target eingerichtet sein. Es kann verstanden werden, dass das hierin für ein Sputtertarget Beschriebene in Analogie gelten kann für mehrere Sputtertargets, beispielsweise wenn eine größere Schichtdicke erreicht werden soll.

Für Phosphor und andere n-leitende Dotanten liegt die oben genannte Dotierstoffkonzentration oberhalb der mittels eines Kristallisationsverfahrens (z.B. Blockguss, Czochralski, usw.) erreichbaren Löslichkeitsgrenze SG in Silizium. Daher kann das Sputtertarget beispielsweise mittels Sinterns und/oder Sprühens und/oder Plasma-Spritzens eines Pulvers hergestellt sein. Dies erleichtert es, die oben genannte Dotierstoffkonzentration zu erreichen und kann selbstverständlich auch für andere Dotanten gelten, je nach Materialsystem.

Der störende Kantenumgriff (wenn eine oder mehr als eine umlaufende Kanten mit der Vermittlerschicht beschichtet ist) entsteht anschaulich bei herkömmlichen Prozesstechnologien dadurch, dass die Abscheidung nicht ohne weiteres auf die zu beschichtende Waferseite begrenzt werden kann. Im Falle der LPCVD kann im Druckbereich des Prozesses das Prozessgas auch zwischen zwei in einem Bootslot stehenden Wafer einströmen und die chemische Reaktion für das Wachstum der Siliziumschicht dort stattfinden. Im Ergebnis wächst die Siliziumschicht überall dort, wo Prozessgase hingelangen können, wobei die Konzentration des Dotierstoffs über die Prozessflüsse der verwendeten Prozessgase eingestellt werden kann. Analoges gilt alternativ oder zusätzlich bei der Verwendung von Abschattungsmasken in inline-Konzepten. Auch im Falle der APCVD und PECVD-Technologien findet aufgrund der ungerichteten Natur der CVD und des konformen Schichtwachstums immer auch an der Waferkante und um die Waferkante herum auf der dem Beschichtungsprozess abgewandten Seite des Wafersubstrats ein unerwünschtes Schichtwachstum statt.

Das Bilden der Vermittlerschicht kann beispielsweise in einer Vakuumanordnung, z.B. einer horizontal ausgerichteten inline-Vakuumanlage, erfolgen, z.B. innerhalb einer Vakuumkammer davon. Aufgrund des gerichteten Schichtwachstums kann der Kantenumgriff gehemmt werden, vorzugsweise indem die Verschattungsmaske verwendet wird. Dies hemmt, dass die dotierte Siliziumdünnschicht um die umlaufende Seitenwand (und/oder beide daran angrenzenden umlaufenden Kanten) des Solarzellenpräkursor herum reicht und/oder die der passivierten Seite gegenüberliegende Seite des Solarzellenpräkursor (elektrisch und/oder körperlich) kontaktiert.

In dem gezeigten Diagramm ist die Abhängigkeit des Resultats einer elektrochemischen Kapazität-Spannungsmessung (eCV) verschiedener Vermittlerschichten, die gemäß verschiedenen Ausführungsformen gebildet wurden, veranschaulicht. Die ohne Reaktivgas gesputterten Vermittlerschichten verfügen über eine Dicke von 100 nm. Die ECV-Messung zeigt den elektrisch aktiven Phosphorgehalt über die Schichtdicke im Zielbereich von bei mehr als 1·10²⁰ at/cm³. Der Gesamtgehalt an Phosphor inklusive des elektrisch inaktiven Phosphors liegt noch höher.

Gemäß verschiedenen Ausführungsformen wird eine Anlagen-Technologie bereitgestellt zur Sputterdeposition einer ausreichend hoch in-situ dotierten (p-Typ >1·10¹⁹ at/cm³, n-Typ >7·10¹⁹ at/cm³) amorphen Silizium-Dünnschicht gemäß einer Soll-Dicke (beispielsweise mehr als 60 nm, z.B. in einem Bereich von ungefähr 60 nm bis ungefähr 200 nm), die ausschließlich auf der zu beschichtenden Oberfläche des Substrats gebildet wird, und damit die Ausbildung eines Kurzschlusses vermeidet. Somit kann in einem nachfolgenden Temperschritt die gewünschte polykristalline Si-Schicht ohne Kantenumgriff und ohne die Ausbildung eines den Wirkungsgrad reduzierenden elektrischen Kurzschlusses hergestellt werden. Zusätzliche Prozessschritte zur nachträglichen Entfernung von Teilbereichen der Siliziumdünnschicht sind nicht unbedingt notwendig.

Diesbezüglich sei darauf hingewiesen, dass ein TOPCon auf der Vorderseite auch eine geringere Schichtdicke aufweisen kann. Beispielsweise kann die vorderseitige Vermittlerschicht 108v eine Dicke von weniger als 60 nm aufweisen, z.B. in einem Bereich von ungefähr 4 nm bis ungefähr 20 nm.

**Fig.9** veranschaulicht eine Vakuumanordnung gemäß verschiedenen Ausführungsformen 900 in einer schematischen Querschnittsansicht, welche mehrere Vakuumkammern 802 aufweist, wovon eine oder mehr als eine Vakuumkammer 802 (dann auch als Prozesskammer bezeichnet) den Beschichtungsbereich 401 bereitstellt.

Die Prozessiervorrichtung kann eine oder mehr als eine Vakuumkammer 802 und im betriebsbereiten Zustand ein Pumpensystem P (aufweisend zumindest eine Grobvakuumpumpe und optional zumindest eine Hochvakuumpumpe) aufweisen, welches mit dem Inneren der Vakuumkammer 802 (auch als Kammerinneres bezeichnet) fluidleitend gekoppelt ist. Gemäß verschiedenen Ausführungsformen kann die oder jede Vakuumkammer 802 ein Kammergehäuse aufweisen, das derart eingerichtet ist, dass in dem Kammerinneren ein Soll-Druck bereitgestellt werden kann. Der Soll-Druck kann in einem Bereich von ungefähr 10 mbar bis ungefähr 1 mbar (mit anderen Worten Grobvakuum) sein oder weniger, z.B. in einem Bereich von ungefähr 1 mbar bis ungefähr 10⁻³ mbar (mit anderen Worten Feinvakuum) oder weniger, z.B. in einem Bereich von ungefähr 10⁻³ mbar bis ungefähr 10⁻⁷ mbar (mit anderen Worten Hochvakuum) oder weniger. Das Pumpensystem kann eingerichtet sein, dem Kammerinneren ein Gas zu entziehen, so dass darin zumindest ein Vakuum (d.h. ein Druck kleiner als 0,3 bar) bereitgestellt sein oder werden kann, beispielsweise der Soll-Druck.

Beispielsweise kann pro Sputtertarget 404, welches in den Beschichtungsbereich 401 hinein zerstäubt wird, eine Prozesskammer oder zumindest ein Kompartment in der Prozesskammer vorhanden sein.

Die Vakuumanordnung kann eingerichtet sein, das hierin beschriebene Verfahren 300 gemäß verschiedenen Ausführungsformen durchzuführen, beispielsweise zur Beschichtung eines oder mehr als eines Solarzellenpräkursors, z.B. eines oder mehr als eines Siliziumwafers (vorzugsweise teilprozessierte Siliziumwafer). Das Verfahren 300 kann einen Teil einer Solarzellenfertigung bereitstellen. Mittels des Verfahrens 300 kann eine dotierte und amorphe (oder zumindest teilkristalline) Vermittlerschicht (z.B. Siliziumdünnschicht) gebildet werden. Der Solarzellenpräkursor kann beispielsweise eine oder mehr als eine mit einem Passivierungsdielektrikum (z.B. einem Tunneloxid) beschichtete Seite (auch als passivierte Seite bezeichnet) aufweisen, die mittels des Verfahrens 300 beschichtet wird.

Die Vakuumanordnung ist beispielsweise eingerichtet in Sputter-Up-Konfiguration, beispielsweise zur einseitigen Beschichtung des Solarzellenpräkursor mit der Vermittlerschicht. Optional kann der Solarzellenpräkursor aber auch beidseitig beschichtet werden, so dass auf dessen gegenüberliegenden Seiten jeweils eine Vermittlerschicht gebildet wird, welche dann einen Abstand voneinander aufweisen (bzw. nicht überlappen).

Optional kann die Vakuumanordnung zumindest eine eingangsseitige als Schleusenkammer eingerichtete Vakuumkammer und/oder eine ausgangsseitige als Schleusenkammer eingerichtet Vakuumkammer aufweisen, zwischen denen der Beschichtungsbereich angeordnet ist. Optional kann der Beschichtungsbereich gassepariert sein, z.B. in mehrere Abschnitte und/oder von seiner Umgebung.

Optional kann die Vakuumanordnung eingerichtet sein als In-line-Anlage (z.B. zwei Schleusenkammern aufweisend) mit mindestens einer Prozesskammer zur einseitigen Beschichtung von mehr als 3000 Solarzellenpräkursoren pro Stunde, bevorzugt mehr als 6000 Solarzellenpräkursoren pro Stunde, weiter bevorzugt mehr als 8000 Solarzellenpräkursoren pro Stunde, mit einer amorphem und/oder dotierten Vermittlerschicht (z.B. Siliziumdünnschicht). Beispielsweise kann die Vermittlerschicht eine Dünnschicht sein, d.h. eine Schichtdicke aufweisen in einem Bereich von ungefähr 5 nm (oder weniger) bis ungefähr 300 nm (oder weniger). Die Vermittlerschicht kann ohne Kantenumgriff bei gleichzeitiger in-situ Dotierung (in mindestens einer Prozesskammer) mit Phosphor von mehr als 7·10¹⁹ at/cm³ gebildet werden.

Dem Beschichtungsbereich 401 bzw. dem Bilden der Vermittlerschicht nachgelagert kann in einer von der Vakuumanordnung separaten Vorrichtung ein Erwärmen des Solarzellenpräkursors erfolgen auf eine Temperatur (auch als Kristallisationstemperatur bezeichnet), der eine Zunahme des Kristallanteils der Vermittlerschicht anregt (auch als Kristallisationsprozess oder Festphasenkristallisation bezeichnet). Die Kristallisationstemperatur kann beispielsweise mehr als ungefähr 500°C sein, als ungefähr 800°C. Die Dauer des Kristallisationsprozess kann mehr als 1 Minute sein, so dass die amorphe Vermittlerschicht (z.B. Si-Schicht) in eine polykristalline Vermittlerschicht (z.B. poly-Si-Schicht) übergeht. Der Kristallisationsprozess kann optional die Eindiffusion des Dotierstoffs durch das Tunneloxid in die Basisschicht anregen.

Das Bilden der Vermittlerschicht erfolgt beispielsweise ungeheizt. Alternativ oder zusätzlich kann der Solarzellenpräkursor vor dem Transport in den Beschichtungsbereich hinein und/oder nach dem Transport aus dem Beschichtungsbereich heraus erwärmt werden, beispielsweise mittels einer Heizvorrichtung 1010 in einer entsprechenden Vakuumkammer 802 (dann auch als Heizerkammer bezeichnet). Das Erwärmen kann beispielsweise den Wassergehalt des Solarzellenpräkursor und/oder des Substratträgers verringern.

Die Dauer (auch als Prozessdauer bezeichnet), die der Solarzellenpräkursor innerhalb des Beschichtungsbereichs ist, kann kleiner sein als ungefähr 5 Minuten, z.B. als ungefähr 1 Minuten, z.B. als ungefähr 40 Sekunden. Beispielsweise kann die Vermittlerschicht innerhalb der Prozessdauer gebildet werden.

**Fig.10** veranschaulicht eine Vakuumanordnung gemäß verschiedenen Ausführungsformen 1000 in einer schematischen Querschnittsansicht, welche mehrere Vakuumkammern 802 aufweist, wovon eine oder mehr als eine Prozesskammer 802 eingerichtet ist, das Verfahren 300 in Sputter-Down-Konfiguration durchzuführen und/oder, wovon eine oder mehr als eine Prozesskammer 802 eingerichtet ist, das Verfahren 300 in Sputter-Up-Konfiguration durchzuführen.

In einer exemplarischen Implementierung kann das Verfahren 300 eingerichtet sein, z.B. mittels einer Verschattungsmaske, beim Bilden der Vermittlerschicht (z.B. Si-Dünnschicht) einen umlaufenden Rand (z.B. zumindest eine umlaufende Kante oder zumindest einen daran angrenzenden umlaufenden Abschnitt der Seitenwand aufweisend) der Waferoberfläche frei zu halten von der Vermittlerschicht, beispielsweise mittels Verschattung durch die Verschattungsmaske. In Sputter-Up-Konfiguration kann ein Randausschluss von ungefähr 1 mm bereitgestellt werden mittels der Verschattung.

In einer exemplarischen Implementierung kann das Verfahren 300 eingerichtet sein zur Vermeidung der Abscheidung der Vermittlerschicht (z.B. Si-Dünnschicht) auf der dem Beschichtungsprozess abgewandten Seite 101 (z.B. Waferoberfläche)
- durch eine geeignete Ausführung von Substrathalterungen und/oder
- durch einen geeigneten Transport des Solarzellenpräkursors durch den Beschichtungsbereich hindurch und/oder
- durch eine geeignete Halterung des Solarzellenpräkursors während des Beschichtens (siehe beispielsweise Pockettiefe und/oder Flankenwinkel), wodurch die gerichtete Abscheidung, beispielsweise die Flugbahn der ballistischen Teilchen des Sputterns begrenzt werden.

In einer exemplarischen Implementierung kann das Verfahren 300 durchgeführt werden in einer In-line PVD-Anlage mit mindestens einer Prozesskammer zur beidseitigen Beschichtung von mehr als 3000 Solarzellenpräkursoren pro Stunde mit einer amorphem Siliziumdünnschicht (5nm < Dicke < 300nm) ohne Kantenumgriff bei gleichzeitiger in-situ Dotierung (in mindestens einer Prozesskammer) einer Seite des Substrates mit einem ersten Dotierstoff der ersten Polarität (z.B. n-dotierung) im Bereich >7·10¹⁹ at/cm³ und der zweiten gegenüberliegenden Oberfläche des Substrats mit einem zweiten Dotierstoff der zweiten Polarität im Bereich >1·10¹⁹ at/cm³.

In einer exemplarischen Implementierung kann das Verfahren 300 eingerichtet sein zum Ausblenden von Randbereichen der Dampfkeule zur Verringerung von P und O-Gehalt in der Schicht. Dies kann beispielsweise mittels einer ortsfesten Verschattungsmaske (beispielsweise in Form einer Blendenvorrichtung) erfolgen.

In einer exemplarischen Implementierung kann das Verfahren 300 eingerichtet sein, einen oder mehr als einen Schichtstapel aus n-dotierter Schicht und undotierter Si-Schicht bereitzustellen, der in der Folge durch die Festphasenkristallisation im Temperschritt (engl. "solid phase crystallization" - SPC) zu einer homogenen Dotierung (z.B. >1·10²⁰ at/cm³) führt.

In einer exemplarischen Implementierung kann das Verfahren 300 durchgeführt werden in einer Sputteranlage.

In einer exemplarischen Implementierung ist die Vermittlerschicht eine Siliziumdünnschicht und/oder eine amorphe Siliziumschicht.

In einer exemplarischen Implementierung weist die Vermittlerschicht eine Schichtdicke d von 5 nm < d < 300nm auf.

In einer exemplarischen Implementierung ist der Dotierstoff der Vermittlerschicht Phosphor.

In einer exemplarischen Implementierung ist das Sputtertarget, mittels dessen die Vermittlerschicht gebildet wird, nicht hergestellt basierend auf Erstarrung einer dotierten Schmelze (z.B. Siliziumschmelze), sondern mittels Sinterns, Spritzens eines Pulvers (wie beispielsweise Si und rotem Phosphor oder Si und einem geeigneten phosphorhaltigen Feststoff wie z.B. Siliziumphosphid).

In einer exemplarischen Implementierung ist die Schichtdicke einer oder mehr als einer dielektrischen Passivierung des Solarzellenpräkursors (z.B. des Tunneloxids) in einem Bereich von ungefähr 0,5 nm bis ungefähr 5 nm, vorzugsweise in einem Bereich von ungefähr 1 nm bis ungefähr 2,5 nm.

In einer exemplarischen Implementierung ist die Schichtdicke einer oder mehr als einer dielektrischen Passivierung des Solarzellenpräkursors vorzugsweise eine SiOx-Schicht. Alternativ oder zusätzlich weist die eine oder mehr als eine dielektrische Passivierung einen (z.B. geringen) Anteil (z.B. geringer als der des Dotierstoffs) von Kohlenstoff und/oder Stickstoff auf.

In einer exemplarischen Implementierung ist die Dotierstoffkonzentration der Vermittlerschicht größer als 1·10²⁰ at/cm³, vorzugsweise größer als 3·10²⁰ at/cm³.

In einer exemplarischen Implementierung weist der Solarzellenpräkursor auf: eine Kantenlänge von mehr als 160 mm, eine dotierte (z.B. n- oder p-dotierte) Basisschicht (die Teil eines Halbleiterübergangs sein kann). Alternativ oder zusätzlich weist der Solarzellenpräkursor eine
Wafergröße von M2, M4, M6, M10, G10, M12 oder G12 auf.

In einer exemplarischen Implementierung weist das Sputtertarget eine Reinheit von mehr als ungefähr 4N (bezogen auf Si und Dotant) auf. Alternativ oder zusätzlich weist das Sputtertarget eine Reinheit von mehr als ungefähr 3N auf (bezogen auf Si und Dotant).

Gemäß verschiedenen Ausführungsformen bietet das Verfahren 300 eine Dotierung und Abscheidung in einem Schritt ohne Gasphasendotierung zwecks Vermeidung von Kantenumgriff, der kostspielig und unter erhöhtem Ausschuss in der Prozessfolge wieder entfernt werden müsste. Dadurch wird eine Kostenersparnis erreicht und die Wirtschaftlichkeit des Verfahrens zur Steigerung des Solarzellenwirkungsgrads verbessert, beispielsweise mittels TOPCon als passivierte Kontakte.

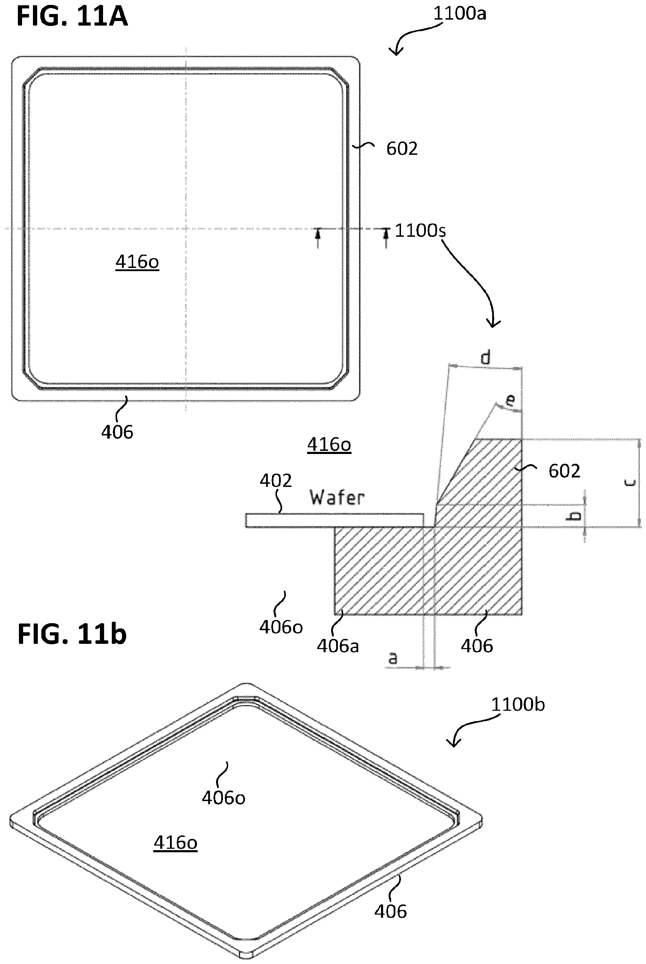

**Fig.11A** veranschaulicht den Substratträger 406 gemäß verschiedenen Ausführungsformen in einer schematischen Draufsicht 1100a und Schnittansicht 1100b und **Fig.11B** in einer Perspektivansicht. Über die geeignete Wahl der Abmessungen a, b, c sowie der beiden Winkel d und e kann das Soll-Beschichtungsergebnis aufgrund der gerichteten Abscheidung im PVD Verfahren ohne Kantenumgriff erreicht werden. Die beiden Winkel d und e sind beispielsweise derart eingerichtet, dass eine konvexe Fläche, welche die Öffnung begrenzt, bereitgestellt ist. Dies begünstigt die Abschattung. Beispiele für die Werte können aufweisen:
- Abstand Substrat zu Taschenwand: a=0,2-2mm, vorzugsweise 0,4mm
- Differenz zwischen Pockettiefe und Wandhöhe: b=0,2-2mm, vorzugsweise 0,7mm
- Pockettiefe: c=1-5mm, vorzugsweise 3mm
- Flankenwinkel unterer Abschnitt der Taschenwand: d=0.1-10°, vorzugsweise 5°;
- Flankenwinkel oberer Abschnitt der Taschenwand: e=10-45°, vorzugsweise 25°.

Die Ausdehnung des Pockets kann beispielsweise eingerichtet sein zum Aufnehmen eines Substrats der Größe M6 (d.h. ungefähr 166 mm Wafer-Kantenlänge).

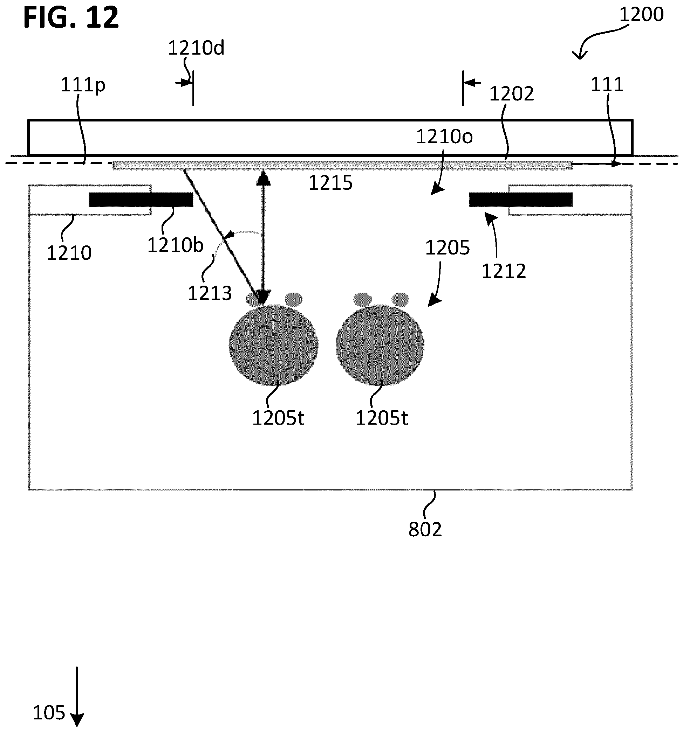

**Fig.12** veranschaulicht eine Beschichtungsanordnung 1200 gemäß verschiedenen Ausführungsformen in einer schematischen Seitenansicht oder Querschnittsansicht. Die Beschichtungsanordnung 1200 weist eine Transportvorrichtung (nicht dargestellt), eine Sputtervorrichtung 1205 und die Blendenvorrichtung 1210, welche eine Verschattungsmaske bereitstellt, auf. Die Transportvorrichtung (nicht dargestellt) ist eingerichtet zum Transportieren eines Solarzellensubstrats 1202 entlang eines Transportpfads 111p in eine Transportrichtung 111.

Im Allgemeinen kann die Sputtervorrichtung 1205 (auch als Magnetron bezeichnet) eine Lagervorrichtung (nicht dargestellt) aufweisen zum (z.B. drehbaren) Lagern eines oder mehr als eines Targets 1205t. Im betriebsfähigen Zustand weist die Sputtervorrichtung 1205 ferner ein oder mehr als ein Target 1205t auf, welches mittels der Lagervorrichtung (z.B. drehbar) gelagert ist. Im hier dargestellten Fall von zwei Targets wird das Magnetron auch als Doppel-Magnetron bezeichnet. Mit anderen Worten kann das eine oder mehr als eine Target 1205t montiert sein, muss dies aber nicht. Ferner kann die Sputtervorrichtung 1205 ein Magnetsystem aufweisen.

Die Blendenvorrichtung 1210, z.B. deren Verschattungsmaske 1212, weist eine Blendenöffnung 1210o auf, die zwischen dem Transportpfad 111p und der Sputtervorrichtung 1205 (z.B. deren Lagervorrichtung und/oder deren Magnetsystem) angeordnet ist. Die Blendenöffnung 1210o (auch als Beschichtungsfenster bezeichnet) kann den Transportpfad 111p gegenüber der Sputtervorrichtung 1205 freilegen. Die Blendenöffnung 1210o weist eine Ausdehnung 1210d (auch als Fensterlänge bezeichnet) entlang des Transportpfads 111p auf. Die Blendenöffnung 1210o bzw. die Fensterlänge 1210d können von einer oder mehr als einer Blende 1210b der Blendenvorrichtung 1210 begrenzt sein oder werden. Je enger die Blenden 1210b beieinander liegen, desto kleiner ist die Blendenöffnung 1210o bzw. die Fensterlänge 1210d. Die Blendenvorrichtung kann derart eingerichtet sein, dass insbesondere der Teil des in Richtung zu dem Transportpfad 111 hin emittierten Beschichtungsmaterials an den Rändern des Beschichtungsbereichs von der Blendenvorrichtung 1210 zumindest teilweise aufgefangen wird. Dies reduziert den Einbau von Sauerstoff in die aus dem Beschichtungsmaterial gebildete Schicht auf dem Solarzellensubstrat 1202.

Anschaulich nimmt die Rate, mit der das Beschichtungsmaterial zu dem Transportpfad 111p hin emittiert wird, mit größerem Winkel 1213 bzw. zu den Rändern des Beschichtungsbereichs (oberhalb des Beschichtungsfensters) hin ab, so dass im Inneren 1215 des Beschichtungsbereichs ein Maximum der Rate vorliegt. Je geringer die Rate ist, desto mehr Reaktionen / Teilchenstöße erfolgen mit Elementen des in der Vakuumkammer vorhandenen Restgases (z.B. N, O, H, C kommend aus Luft und eingeschleppter Wasserfeuchte). Allgemeiner ausgedrückt, ist die Wechselwirkung zwischen dem Beschichtungsmaterial und molekularem Gas (bzw. dessen Ionen) nahe den Blenden 1210b größer als im Inneren 1215 des Beschichtungsbereichs, was einen erhöhten Einbau dieser Elemente in die abgeschiedene Schicht zur Folge haben kann, wenn die Ränder des Beschichtungsbereichs nicht ausgeblendet werden.

Beispielsweise kann mittels der Blendenvorrichtung weniger als 30%, z.B. weniger als 10%, des zerstäubten Beschichtungsmaterials aufgefangen werden. Beispielsweise kann mittels der Blendenvorrichtung mehr als 5%, z.B. mehr als 25%, des zerstäubten Beschichtungsmaterials aufgefangen werden. Beispielsweise kann mittels der Blendenvorrichtung im betriebsbereiten Zustand (d.h. Ist-Fensterlänge = Soll-Fensterlänge) ein Anteil von Beschichtungsmaterial (verglichen mit dem gesamten emittierten Beschichtungsmaterial) aufgefangen werden in einem Bereich von ungefähr 5% bis ungefähr 40%.

Die den Einbau von Elementen (beispielsweise N, O, H oder C) aus dem Restgas hemmende Wirkung der Blendenvorrichtung 1210 wird ferner verbessert, wenn der Rand der Blendenöffnung 1210o bzw. die Blenden 1210b möglichst nah am Transportpfad (auch als Substrat-nah bezeichnet) angeordnet sind. Die oder jede Blende 1210b kann beispielsweise eine Platte aufweisen, welche beispielsweise verschiebbar und/oder arretierbar mittels eines Gestells der Blendenvorrichtung 1210 gelagert ist. Als Blenden 1210b kann hierein auch jegliche Begrenzung der Blendenöffnung 1210o (auch als Sputterfenster bezeichnet) verstanden werden, z.B. mittels eines oder mehr als eines L-förmigen Schilds und/oder mittels der einen Kammerwand der Vakuumkammer 802 (auch als Kammerbegrenzung bezeichnet). Der Abstand der Blende 1210b zu dem Transportpfad 111p (auch als Substratebene bezeichnet) kann möglichst klein eingerichtet sein, beispielsweise kleiner je höher der verwendete Prozessdruck ist, was die Ausbreitung von Streudampf hinter den Blenden hemmt. Beispielsweise kann der Abstand zwischen der oder jeder Blende 1210b und dem Transportpfad 111p kleiner sein als ungefähr 3 cm (Zentimeter), beispielsweise kleiner als ungefähr 1 cm, beispielsweise kleiner als ungefähr 0,5 cm, beispielsweise kleiner als ungefähr 0,25 cm.

Gemäß verschiedenen Ausführungsformen kann mittels der Beschichtungsanordnung 1200 das Zerstäuben von aSi:X und Beschichten mit diesem, oder allgemeiner gesprochen, eines sauerstoff-armen bzw. -freien (z.B. hochreaktiven) Materials, erleichtert werden.

Im Folgenden werden verschiedene Beispiele beschrieben, die sich auf das vorangehend Beschriebene und in den Figuren Dargestellte beziehen.

Beispiel 1 ist ein Verfahren zum Bearbeiten eines Solarzellenpräkursors (z.B. mittels eines Vakuumsystems), welcher eine mit zumindest einem (d.h. einem oder mehr als einem) Dielektrikum, vorzugsweise zumindest einem Oxid (z.B. Halbleiteroxid, z.B. Siliziumoxid), bedeckte (z.B. vorzugsweise beschichtete und/oder vorzugsweise passivierte) Seite aufweist, das Verfahren aufweisend: Zerstäuben eines Sputtertargets in einen Beschichtungsbereich hinein, wobei das Sputtertarget ein Halbleitermaterial und einen Dotanten des Halbleitermaterials aufweist; Anordnen des Solarzellenpräkursors (der optional in einem Substratträger eingelegt ist) in dem Beschichtungsbereich, wenn das Zerstäuben des Sputtertargets in den Beschichtungsbereich hinein erfolgt derart, dass die Seite dem Sputtertarget zugewandt ist (und/oder das Dielektrikum dem zerstäubten Sputtertarget, z.B. dem Halbleitermaterial und dem Dotanten davon, ausgesetzt ist); wobei der Substratträger weiter vorzugsweise derart eingerichtet ist, dass zumindest eine (d.h. eine oder mehr als eine) entlang eines in sich geschlossenen Pfades verlaufende Kante des Solarzellenpräkursors mittels des Substratträgers von dem Zerstäuben des Sputtertargets abgeschattet wird (z.B. derart, dass diese frei bleibt von dem zerstäubten Sputtertarget, z.B. dem Halbleitermaterial und dem Dotanten davon). Die Seite kann beispielsweise mit dem Dielektrikum beschichtet sein, z.B. indem das Dielektrikum abgeschieden und/oder mittels einer chemischen Reaktion (z.B. CVD und/oder Oxidation) gebildet wird.

Beispiel 2 ist ein Verfahren (z.B. gemäß Beispiel 1) zum Bearbeiten eines Solarzellenpräkursors (z.B. mittels eines Vakuumsystems), welcher eine mit zumindest einem (d.h. einem oder mehr als einem) Dielektrikum, vorzugsweise zumindest einem Oxid (z.B. Halbleiteroxid, z.B. Siliziumoxid), bedeckte (z.B. vorzugsweise beschichtete und/oder vorzugsweise passivierte) Seite aufweist, das Verfahren aufweisend: Zerstäuben eines Sputtertargets in Richtung zu der Seite, die dem Sputtertarget zugewandt ist, hin, wobei das Sputtertarget ein Halbleitermaterial und einen Dotanten des Halbleitermaterials aufweist; Bilden einer Schicht auf der Seite mittels des Zerstäubens des Sputtertargets, wobei die Schicht ein kleineres Mengenverhältnis des Dotanten zu dem Halbleitermaterial aufweist als das Sputtertarget oder dasselbe Mengenverhältnis; wobei der Solarzellenpräkursor vorzugsweise in einem Substratträger eingelegt ist, der weiter vorzugsweise derart eingerichtet ist, dass eine entlang eines in sich geschlossenen Pfades verlaufende Kante des Solarzellenpräkursors mittels des Substratträgers von dem Zerstäuben des Sputtertargets abgeschattet wird.

Beispiel 3 ist ein Vakuumsystem (z.B. das Vakuumsystem in dem Beispiel 1 oder 2) oder dessen Verwendung, wobei das Vakuumsystem den Beschichtungsbereich und das Sputtertarget und optional ein Transportsystem aufweist, und/oder wobei das Vakuumsystem zum Durchführen des Verfahrens gemäß Anspruch 1 oder 2 eingerichtet ist oder verwendet wird.

Beispiel 4 ist das Vakuumsystem gemäß Beispiel 3, ferner aufweisend: das Transportsystem, mittels welchem das Anordnen des Solarzellenpräkursors erfolgt, vorzugsweise indem der Solarzellenpräkursor mittels des Transportsystems entlang eines Transportpfads in einem Inneren des Vakuumsystems transportiert wird.

Beispiel 5 ist das Vakuumsystem gemäß Beispiel 3 oder 4, wobei das Transportsystem beispielsweise einen Substratträger aufweist und/oder eingerichtet ist zum Transportieren eines Solarzellenpräkursors (vorzugsweise der in dem Substratträger eingelegt ist) in dem Beschichtungsbereich, wenn das Zerstäuben des Sputtertargets in den Beschichtungsbereich hinein erfolgt, vorzugsweise derart, dass eine mit zumindest einem Dielektrikum beschichtete Seite des Solarzellenpräkursors dem Sputtertarget zugewandt ist, wobei der Substratträger vorzugsweise eingerichtet ist, dass eine entlang eines in sich geschlossenen Pfades verlaufende Kante des Solarzellenpräkursors mittels des Substratträgers gegenüber dem Zerstäuben des Sputtertargets abgeschattet wird.

Beispiel 6 ist das Vakuumsystem gemäß einem der Beispiele 3 bis 5, ferner aufweisend: eine erste Vakuumkammer, in welcher der Beschichtungsbereich angeordnet ist, eine zweite Vakuumkammer, welche an die erste Vakuumkammer angrenzt (beispielsweise dieser vorgeschaltet oder nachgeschaltet), wobei die zweite Vakuumkammer mehr Heizleistung pro Transportstrecke, entlang welcher der Solarzellenpräkursor durch die erste Vakuumkammer und die zweite Vakuumkammer transportiert wird, aufweist als die erste Vakuumkammer.

Beispiel 7 ist das Vakuumsystem gemäß einem der Beispiele 3 bis 6, ferner aufweisend: eine oder mehr als eine Vakuumkammer (z.B. die erste Vakuumkammer und/oder zweite Vakuumkammer aufweisend), in welcher der Beschichtungsbereich angeordnet ist.

Beispiel 8 ist das Vakuumsystem gemäß einem der Beispiele 3 bis 7, ferner aufweisend: eine Sputtervorrichtung mit dem Sputtertarget, wobei die Sputtervorrichtung beispielsweise eingerichtet ist, das Sputtertarget in den Beschichtungsbereich hinein zu zerstäuben.

Beispiel 9 ist das Vakuumsystem gemäß einem der Beispiele 3 bis 8, ferner aufweisend: wobei das Sputtertarget ein Halbleitermaterial aufweist und/oder wobei das Sputtertarget einen Dotanten des Halbleitermaterials aufweist in einer Menge, die größer ist als eine Löslichkeitsgrenze SG des Dotanten in dem Halbleitermaterial und/oder als ein Stoffmengenanteil des Dotanten von 0,15%.

Beispiel 10 ist das Vakuumsystem gemäß einem der Beispiele 3 bis 9, ferner aufweisend: eine Beschichtungsvorrichtung, welche eingerichtet ist, das Dielektrikum auf der Seite des Solarzellenpräkursors zu bilden in einem zusätzlichen Beschichtungsbereich, der in der einen oder mehr als einen Vakuumkammer dem Beschichtungsbereich vorgelagert angeordnet ist.

Beispiel 11 ist das Vakuumsystem gemäß einem der Beispiele 3 bis 10, wobei ein Soll-Zustand des Vakuumsystems im Betrieb (z.B. gemäß dem das Vakuumsystem betrieben wird) derart eingerichtet ist, dass eine Temperatur des Solarzellenpräkursor, wenn dieser in dem Beschichtungsbereich angeordnet ist oder wird, vorzugsweise wenn dieser den Beschichtungsbereich erreicht, weniger als ungefähr 200°C, vorzugsweise als ungefähr 100°C, und/oder von weniger als eine Temperatur des Sputtertargets ist.

Beispiel 12 ist das Vakuumsystem gemäß einem der Beispiele 3 bis 11, ferner aufweisend: eine Gastransfervorrichtung, welche eingerichtet ist, dem Beschichtungsbereich eine Gaszusammensetzung zuzuführen und/oder zu entziehen (z.B. durch die Schnellkupplung hindurch); wobei die Gastransfervorrichtung vorzugsweise eine Schnellkupplung, eine Pumpe und/oder eine Gasquelle (z.B. die Gaszusammensetzung aufweisend) aufweist (die beispielsweise der Gaszusammensetzung ausgesetzt sind), wobei beispielsweise die Gaszusammensetzung: ein Inertgas, vorzugsweise ein Edelgas, aufweist oder daraus gebildet ist; und/oder einen kleineren Stoffmengenanteil des Dotanten aufweist als das Sputtertarget, vorzugsweise im Wesentlichen frei von dem Dotanten ist; und/oder einen kleineren Stoffmengenanteil Wasserstoff aufweist als der Beschichtungsbereich, vorzugsweise im Wesentlichen frei von Wasserstoff ist. Die Schnellkupplung reflektiert, dass eine solche Gaszusammensetzung (z.B. gefahrfrei) verwendet werden kann. Ist die Gaszusammensetzung gefährlicher (z.B. Wasserstoff und/oder den Dotanten aufweisend), wird die Schnellkupplung hingegen weggelassen.

Beispiel 13 ist das Vakuumsystem gemäß Beispiel 12, ferner aufweisend: ein einwandiges Rohr, mittels welchem der Beschichtungsbereich mit der Gastransfervorrichtung gekoppelt ist; und/oder eine zusätzliche Schnellkupplung, mittels welcher der Beschichtungsbereich mit der Gastransfervorrichtung gekoppelt ist. Das einwandige Rohr reflektiert, dass eine ungefährliche Gaszusammensetzung verwendet werden kann. Ist die Gaszusammensetzung gefährlicher (z.B. Wasserstoff und/oder den Dotanten aufweisend), wird das Rohr mindestens doppelwandig ausgeführt. Die Schnellkupplung reflektiert, dass eine solche Gaszusammensetzung (z.B. gefahrfrei) verwendet werden kann. Ist die Gaszusammensetzung gefährlicher (z.B. Wasserstoff und/oder den Dotanten aufweisend), wird die Schnellkupplung hingegen weggelassen.

Beispiel 14 ist eingerichtet gemäß einem der Beispiele 1 bis 13, wobei der Solarzellenpräkursor, wenn dieser in dem Beschichtungsbereich angeordnet ist und/oder wenn das Zerstäuben des Sputtertargets in den Beschichtungsbereich hinein erfolgt, eine Temperatur von weniger als ungefähr 200°C, vorzugsweise weniger als ungefähr 100°C, und/oder von weniger als einer Temperatur des Sputtertargets aufweist.

Beispiel 15 ist eingerichtet gemäß einem der Beispiele 1 bis 14, wobei das Zerstäuben des Sputtertargets in den Beschichtungsbereich hinein erfolgt, wenn der Solarzellenpräkursor in dem Beschichtungsbereich angeordnet und/oder in diesen hinein und/oder aus diesem heraus transportiert wird.

Beispiel 16 ist eingerichtet gemäß einem der Beispiele 1 bis 15, wobei der Solarzellenpräkursor aufweist: eine erste (zusammenhängend) umlaufende Kante (die beispielsweise an die Seite angrenzt), eine zweite (zusammenhängend) umlaufende Kante (die beispielsweise der Seite gegenüberliegt oder zumindest einen Abstand von dieser aufweist) und/oder eine (zusammenhängend) umlaufende Seitenwand, die an die erste Kante und/oder die zweite Kante angrenzt (z.B. zwischen diesen angeordnet ist), wobei die zumindest eine Kante die erste umlaufende Kante und/oder die zweite umlaufende Kante aufweist.

Beispiel 17 ist eingerichtet gemäß einem der Beispiele 1 bis 16, wobei die zumindest eine Kante an das zumindest eine Dielektrikum angrenzt oder einen Abstand von dem zumindest einen Dielektrikum aufweist.

Beispiel 18 ist eingerichtet gemäß einem der Beispiele 1 bis 17, wobei das Sputtertarget den Dotanten in einer Menge (beispielsweise einem Mengenverhältnis des Dotanten zu dem Halbleitermaterial) aufweist, die größer ist als eine Löslichkeitsgrenze des Dotanten in dem Halbleitermaterial.

Beispiel 19 ist eingerichtet gemäß einem der Beispiele 1 bis 18, wobei das Sputtertarget den Dotanten in einer Menge aufweist, die größer ist als ein Anteil (z.B. Stoffmengenanteil und/oder Massenanteil) des Dotanten von 0,15% (beispielsweise bezogen auf das Gemisch von Dotant und Halbleitermaterial und/oder bezogen auf die Masse des Sputtertargets), z.B. von 0,15 gew% oder von 0,15 at%.

Beispiel 20 ist eingerichtet gemäß einem der Beispiele 1 bis 19, wobei der Substratträger eine Verschattungsmaske aufweist, mittels welcher die Kante abgeschattet wird und/oder durch welche das Sputtertarget hindurch zerstäubt wird (z.B. zu dem Solarzellenpräkursor hin); wobei die Verschattungsmaske beispielsweise mittels einer Substratauflage des Substratträgers, auf welcher der Solarzellenpräkursor aufliegt, bereitgestellt wird, oder wobei die Verschattungsmaske beispielsweise eine Öffnung aufweist, in welcher der Solarzellenpräkursor eingelegt ist; wobei die Verschattungsmaske beispielsweise mittels einer Wand bereitgestellt wird, die eine Vertiefung (z.B. Substrataufnahmetasche), in welche der Solarzellenpräkursor eingelegt ist, begrenzt; und/oder wobei die Verschattungsmaske eine Öffnung aufweist, durch welche das Sputtertarget hindurch zerstäubt wird (z.B. zu dem Solarzellenpräkursor hin).

Beispiel 21 ist eingerichtet gemäß einem der Beispiele 1 bis 20, wobei der Substratträger (z.B. dessen Verschattungsmaske) eine Öffnung aufweist, welche den Solarzellenpräkursor gegenüber dem Sputtertarget freilegt, wobei die Öffnung beispielsweise von einem umlaufenden Rand des Substratträgers (z.B. dessen die Öffnung umlaufender Seitenwand) und/oder einer konvexen (z.B. umlaufenden) Fläche des Substratträgers (z.B. dessen die Öffnung umlaufender Seitenwand) begrenzt wird; und/oder wobei die Verschattungsmaske (z.B. deren Rand) derart eingerichtet ist, dass zumindest ein an die zumindest eine Kante angrenzender Rand des Solarzellenpräkursors mit einer Randbreite von mehr als 0,1 mm (z.B. als 1 mm) abgeschattet wird.

Beispiel 22 ist eingerichtet gemäß einem der Beispiele 1 bis 21, wobei die Kante dem Sputtertarget abgewandt ist.

Beispiel 23 ist eingerichtet gemäß einem der Beispiele 1 bis 22, wobei ferner aufweisend: Bilden einer Schicht (z.B. der Vermittlerschicht) auf dem Solarzellenpräkursor mittels des Zerstäubens des Sputtertargets, wobei die Schicht vorzugsweise ein kleineres Mengenverhältnis des Dotanten zu dem Halbleitermaterial aufweist als das Sputtertarget oder dasselbe Mengenverhältnis.

Beispiel 24 ist eingerichtet gemäß Beispiel 23, wobei die Schicht zumindest teilweise (d.h. teilweise oder vollständig) amorph ist und/oder einen Schichtwiderstand (z.B. bezogen auf 100 nm Schichtdicke) von mindestens ungefähr 1000 Ohm aufweist (z.B. unmittelbar nachdem die Schicht gebildet ist), z.B. mindestens ungefähr 2000 Ohm aufweist.

Beispiel 25 ist eingerichtet gemäß Beispiel 23 oder 24, wobei die Schicht zumindest teilweise (d.h. teilweise oder vollständig) polykristallin ist und/oder einen Schichtwiderstand (z.B. bezogen auf 100 nm Schichtdicke) von weniger als ungefähr 1000 Ohm aufweist (z.B. nachdem diese zum Kristallisieren angeregt wurde, z.B. mittels eines Kristallisationsprozesses und/oder mittels Erwärmens der Schicht), z.B. weniger als ungefähr 200 Ohm aufweist.

Beispiel 26 ist eingerichtet gemäß einem der Beispiele 23 bis 25, wobei die Menge des Dotanten (z.B. das Mengenverhältnis des Dotanten zu dem Halbleitermaterial) in der Schicht größer ist: als eine Löslichkeitsgrenze des Dotanten in dem Halbleitermaterial; und/oder als 0,15% (z.B. at% oder gew%).

Beispiel 27 ist eingerichtet gemäß einem der Beispiele 23 bis 26, wobei die Schicht eine Konzentration des Dotanten aufweist die größer ist als ungefähr 7·10¹⁹ at/cm³, vorzugsweise als ungefähr 1·10²⁰ at/cm³.

Beispiel 28 ist eingerichtet gemäß einem der Beispiele 23 bis 27, wobei die Schicht das Halbleitermaterial aufweist und/oder mit dem Dotant dotiert ist, beispielsweise mit demselben Dotierungstyp wie eine Basis des Solarzellenpräkursors (wenn die Seite die Rückseite des Solarzellenpräkursor ist) oder mit dem gegenpoligen Dotierungstyp wie die Basis des Solarzellenpräkursors (wenn die Seite die Vorderseite des Solarzellenpräkursor ist).

Beispiel 29 ist eingerichtet gemäß einem der Beispiele 23 bis 28, ferner aufweisend: Erwärmen der Schicht, vorzugsweise nach einem Ausschleusen des Solarzellenpräkursor aus einem Vakuum, beispielsweise derart, dass ein Kristallanteil der Schicht zunimmt (beispielsweise so dass eine Festphasenkristallisation erfolgt); und/oder beispielsweise derart, dass das Dielektrikum den Dotant aus der Schicht aufnimmt (z.B. mittels des Dotanten der Schicht dotiert wird), und/oder beispielsweise derart, dass die Schicht in Kombination mit dem darunterliegenden Dielektrikum (z.B. SiOx) einen passivierten Kontakt ausbildet.

Beispiel 30 ist eingerichtet gemäß einem der Beispiele 23 bis 29, wobei die Schicht (z.B. amorphes) Silizium aufweist oder daraus gebildet ist.

Beispiel 31 ist eingerichtet gemäß einem der Beispiele 1 bis 30, wobei der Solarzellenpräkursor: erwärmt wird (vorzugsweise im Vakuum), bevor dieser in den Beschichtungsbereich hinein transportiert wird; und/oder mehr Wärmeleistung abgibt als aufnimmt (vorzugsweise im Vakuum), wenn diese in dem Beschichtungsbereich hinein transportiert wird (beispielsweise so dass die Temperatur des Solarzellenpräkursors sinkt).

Beispiel 32 ist eingerichtet gemäß einem der Beispiele 1 bis 31, wobei der Beschichtungsbereich ein Vakuum aufweist.

Beispiel 33 ist eingerichtet gemäß einem der Beispiele 1 bis 32, wobei das Anordnen des Solarzellenpräkursors in dem Beschichtungsbereich derart erfolgt, dass dieser mit der Seite und/oder dem Dielektrikum dem Sputtertarget zugewandt ist.

Beispiel 34 ist eingerichtet gemäß einem der Beispiele 1 bis 33, wobei die Seite eine Vorderseite des Solarzellenpräkursor oder eine Rückseite des Solarzellenpräkursor ist, wobei die Vorderseite und die Rückseite vorzugsweise einander gegenüberliegen.

Beispiel 35 ist eingerichtet gemäß einem der Beispiele 1 bis 34, wobei der Solarzellenpräkursor eine Basisschicht (z.B. einen Wafer) und/oder und einen Emitter (z.B. eine Emitterschicht) aufweist, wobei der Emitter beispielsweise auf der Seite angeordnet bzw. dem Sputtertarget zugewandt oder davon abgewandt ist (beispielsweise bezogen auf die Basisschicht); wobei der Emitter und die Basisschicht beispielsweise einen Halbleiterübergang bilden.

Beispiel 36 ist eingerichtet gemäß einem der Beispiele 1 bis 35, wobei das zumindest eine Dielektrikum die Basisschicht oder den Emitter berührt.

Beispiel 37 ist eingerichtet gemäß einem der Beispiele 1 bis 36, ferner aufweisend: Erwärmen der Solarzelle, wenn diese aus dem Beschichtungsbereich heraus transportiert wird, so dass die Temperatur des Solarzellenpräkursors zunimmt.

Beispiel 38 ist eingerichtet gemäß einem der Beispiele 1 bis 37, wobei das Zerstäuben des Sputtertargets mittels eines Plasmas erfolgt, welches zwischen dem Sputtertarget und dem Solarzellenpräkursor gebildet wird.

Beispiel 39 ist eingerichtet gemäß einem der Beispiele 1 bis 38, wobei der Solarzellenpräkursor in dem Beschichtungsbereich einer chemischen Zusammensetzung ausgesetzt ist, die ein kleineres Mengenverhältnis des Dotanten zu dem Halbleitermaterial aufweist als das Sputtertarget oder dasselbe Mengenverhältnis; und/oder weniger Wasserstoffatome als Atome des Dotanten aufweist, vorzugsweise im Wesentlichen frei von Wasserstoff ist.

Beispiel 40 ist eingerichtet gemäß einem der Beispiele 1 bis 39, wobei das zumindest eine Dielektrikum das Halbleitermaterial, z.B. ein Oxid (z.B. SiOx) dessen, aufweist.

Beispiel 41 ist eingerichtet gemäß einem der Beispiele 1 bis 40, wobei das zumindest eine Dielektrikum eine Dicke von weniger als ungefähr 5 nm aufweist, z.B. als ungefähr 2 nm, und/oder eine Dicke von 1,5 nm aufweist.

Beispiel 42 ist eingerichtet gemäß einem der Beispiele 1 bis 41, wobei die Seite (z.B. dem Sputtertarget zugewandte Seite) des Solarzellenpräkursors (z.B. Rückseite oder Vorderseite) mittels einer dielektrischen Schicht, vorzugsweise aus dem zumindest einem Dielektrikum, beschichtet (z.B. passiviert) ist, welche eine Dicke von weniger als 5 Nanometer, vorzugsweise weniger als 2,5 Nanometer, aufweist.

Beispiel 43 ist eingerichtet gemäß einem der Beispiele 1 bis 42, wobei das Anordnen des Solarzellenpräkursors in dem Beschichtungsbereich mittels eines Transportsystems erfolgt, welches den Substratträger aufweist, in dem der Solarzellenpräkursor und vorzugsweise eine Vielzahl (z.B. mehr als 10, mehr als 50 oder mehr als 100) zusätzlicher Solarzellenpräkursoren, eingelegt ist/sind.

Beispiel 44 ist eingerichtet gemäß einem der Beispiele 1 bis 43, wobei der Substratträger vorzugsweise eine Substratauflage (z.B. die Verschattungsmaske bereitstellend) aufweist, der eine Durchgangsöffnung aufweist, die zwischen dem Solarzellenpräkursor und dem Sputtertarget angeordnet ist, wenn der Solarzellenpräkursor in dem Beschichtungsbereich angeordnet ist.

Beispiel 45 ist eingerichtet gemäß einem der Beispiele 1 bis 44, wobei das Sputtertarget eine Konzentration des Dotanten aufweist die größer ist als 7·10¹⁹ at/cm³, vorzugsweise als >2,35·10²⁰ at/cm³, weiter vorzugsweise als >1·10²¹ at/cm³.

Beispiel 46 ist eingerichtet gemäß einem der Beispiele 1 bis 45, wobei das Sputtertarget monolithisch ausgebildet ist und/oder mittels eines Trägerrohrs getragen wird, das sich durch das Sputtertarget hindurch erstreckt.

Beispiel 47 ist eingerichtet gemäß einem der Beispiele 1 bis 46, wobei das Sputtertarget gespritzt oder gesintert ist und/oder wobei das Sputtertarget mittels Spritzverfahren oder Sinterverfahren hergestellt ist.

Beispiel 48 ist eingerichtet gemäß einem der Beispiele 1 bis 47, wobei das Sputtertarget eine Reinheit des Halbleitermaterials aufweist von mehr als 99,9 at% (3N), vorzugsweise mehr als 99,99 at% (4N), beispielsweise wenn der Dotant abgezogen wird. Beispielsweise kann der Anteil (z.B. Massenanteil und/oder Stoffmengenanteil) der Summe aus Halbleitermaterial und Dotant größer sein als 99,9% des Sputtertargets, z.B. größer sein als 99,99% des Sputtertargets (der Rest, z.B. außer Si und P, könnte beispielsweise weniger sein als 0,1% oder 0,01%).

Beispiel 49 ist eingerichtet gemäß einem der Beispiele 1 bis 48, wobei eine chemische Zusammensetzung des Sputtertargets, wenn der Dotant abgezogen wird, eine Reinheit des Halbleitermaterials aufweist von mehr als 99,999 at% (5N), vorzugsweise mehr als 99,9999 at% (6N).

Beispiel 50 ist eingerichtet gemäß einem der Beispiele 1 bis 49, wobei das Halbleitermaterial Silizium aufweist oder Silizium ist.

Beispiel 51 ist eingerichtet gemäß einem der Beispiele 1 bis 50, wobei der Dotant Phosphor aufweist oder Phosphor ist; und/oder wobei der Dotant Arsen aufweist oder Arsen ist.

Beispiel 52 ist eingerichtet gemäß einem der Beispiele 1 bis 51, wobei zwischen dem Beschichtungsbereich und dem Sputtertarget eine Durchgangsöffnung (auch als Blendenöffnung bezeichnet) einer (z.B. ortsfest zu dem Target angeordneten) Blendenvorrichtung angeordnet ist, welche mittels des Zerstäubens des Sputtertargets beschichtet wird, und beispielsweise dadurch einen Randanteil des zerstäubten Materials, der stärker mit der Hintergrundatmosphäre wechselwirken kann, ausblendet (beispielsweise verhindert, dass das ausgeblendete Material den Beschichtungsbereich erreicht).

Beispiel 53 ist eingerichtet gemäß einem der Beispiele 1 bis 52, wobei der Beschichtungsbereich in einer oder mehr als einer Vakuumkammer (die beispielsweise ein gemeinsames Vakuumsystem bilden oder Teil dessen sind) angeordnet ist.

Beispiel 54 ist eingerichtet gemäß einem der Beispiele 1 bis 53, ferner aufweisend: Bilden des zumindest einen Dielektrikums vorzugsweise innerhalb des Vakuumsystems und/oder vorzugsweise mittels physikalischer Gasphasenabscheidung.

Beispiel 55 ist eingerichtet gemäß einem der Beispiele 1 bis 54, wobei die zumindest eine Kante des Solarzellenpräkursors im Wesentlichen nicht (mittels des Sputtertargets und/oder mittels des Halbleitermaterials des Sputtertargets) beschichtet wird, wenn (z.B. solange) der Solarzellenpräkursor in dem Beschichtungsbereich angeordnet ist.

Beispiel 56 ist eingerichtet gemäß einem der Beispiele 1 bis 55, ferner aufweisend: Bilden eines zusätzlichen Dielektrikums (z.B. SiN) auf dem Solarzellenpräkursor (vorzugsweise auf der mittels des Zerstäubens des Sputtertargets gebildeten Schicht, beispielsweise wenn die Seite die Rückseite ist), nachdem der Solarzellenpräkursor aus dem Beschichtungsbereich heraus gebracht ist, vorzugsweise innerhalb des Vakuumsystems, wobei das Bilden des zusätzlichen Dielektrikums vorzugsweise mittels einer chemischen Reaktion und/oder einer physikalischen Gasphasenabscheidung, vorzugsweise mittels einer reaktiven physikalischen Gasphasenabscheidung, erfolgt.

Beispiel 57 ist eingerichtet gemäß einem der Beispiele 1 bis 56, ferner aufweisend: zusätzliches Beschichten einer Vorderseite des Solarzellenpräkursors, welche beispielsweise die Seite ist oder der Seite (z.B. Rückseite) gegenüberliegt, vorzugsweise innerhalb des Vakuumsystems, wobei das Beschichten der Seite vorzugsweise mittels physikalischer Gasphasenabscheidung und/oder außerhalb des Beschichtungsbereichs (z.B. in einem zusätzlichen Beschichtungsbereich) erfolgt.

Beispiel 58 ist eingerichtet gemäß Beispiel 57, das zusätzliche Beschichten der Vorderseite ferner aufweisend: Bilden einer Schicht auf der Vorderseite, welche das Halbleitermaterial aufweist und/oder dotiert, vorzugsweise mit dem gegenpoligen Dotierungstyp wie der Dotant der Rückseite, ist. Beispielsweise kann die Vorderseite mit SiOx und mit noch einem aSi mit gegenpoliger Dotierung beschichtet werden, so dass die Rückseite n-dotiert und die Vorderseite p-dotiert (oder umgekehrt) ist. Das SiOx kann optional auch weggelassen werden.

Beispiel 59 ist eingerichtet gemäß Beispiel 58, wobei das zusätzliche Beschichten der Vorderseite erfolgt mittels eines zusätzlichen Sputtertargets und/oder in dem Vakuumsystem. Beispielsweise kann die Vorderseite mit aSi beschichtet sein oder werden, beispielsweise alternativ oder zusätzlich zu dem Beschichten der Rückseite.

Beispiel 60 ist eingerichtet gemäß einem der Beispiele 1 bis 59, wobei eine entlang der Kante verlaufende laterale Fläche des Solarzellenpräkursors im Wesentlichen nicht beschichtet wird, wenn der Solarzellenpräkursor in dem Beschichtungsbereich angeordnet ist.

Beispiel 61 ist eingerichtet gemäß einem der Beispiele 1 bis 60, wobei dem Beschichtungsbereich eine Gaszusammensetzung zugeführt und/oder entzogen wird, wenn das Zerstäuben des Sputtertargets erfolgt, wobei die Gaszusammensetzung: ein Inertgas, vorzugsweise ein Edelgas, aufweist oder daraus gebildet ist; und/oder einen kleineren Stoffmengenanteil des Dotanten aufweist als das Sputtertarget, vorzugsweise im Wesentlichen frei von dem Dotanten ist; und/oder einen kleineren Stoffmengenanteil Wasserstoff aufweist als der Beschichtungsbereich, vorzugsweise im Wesentlichen frei von Wasserstoff ist.

Beispiel 62 ist eingerichtet gemäß einem der Beispiele 1 bis 61, wobei der Solarzellenpräkursor aufweist: eine Emitterschicht und eine Kollektorschicht (z.B. die Basisschicht), die einen Halbleiterübergang (z.B. pn-Übergang) bilden; wobei der Solarzellenpräkursor vorzugsweise das zumindest eine Dielektrikum (z.B. eine dielektrische Schicht bildend) zwischen einer mittels des Sputtertargets gebildeten (z.B. dotieren und/oder amorphen) Halbleiterschicht und der Kollektorschicht aufweist.

Beispiel 63 ist eingerichtet gemäß einem der Beispiele 1 bis 62, wobei mittels des Sputtertargets und einem diesen nachgelagerten Tempern eine dotierte polykristalline Halbleiterschicht auf der Seite (z.B. Rückseite oder Vorderseite) des Solarzellenpräkursors gebildet wird.

Beispiel 64 ist eingerichtet gemäß einem der Beispiele 1 bis 63, wobei eine mittels Zerstäubens des Sputtertargets gebildete Schicht eine Dicke aufweist von mehr als 60 nm (z.B. in einem Bereich von ungefähr 60 nm bis ungefähr 100 nm) oder weniger als 60 nm (z.B. in einem Bereich von ungefähr 4 nm bis ungefähr 20 nm), beispielsweise wobei der Solarzellenpräkursor aus dem Beschichtungsbereich (z.B. aus dem zerstäubten Sputtertarget) heraus bewegt wird (z.B. nach dem Beschichten mittels des Sputtertargets), wenn die mittels Zerstäubens des Sputtertargets gebildete Schicht die Dicke aufweist von mehr als 60 nm (z.B. in einem Bereich von ungefähr 60 nm bis ungefähr 100 nm) oder weniger als 60 nm (z.B. in einem Bereich von ungefähr 4 nm bis ungefähr 20 nm).

Beispiel 65 ist eingerichtet gemäß einem der Beispiele 1 bis 64, wobei das Zerstäuben des Sputtertargets derart erfolgt, dass eine dabei gebildete Schicht (z.B. Vermittlerschicht), eine Menge (z.B. Dichte) an Korngrenzen aufweist, die beispielsweise aufgrund der im Vergleich zu CVD-gestützten Verfahren (wie z.B. LPCVD, PECVD) um den Faktor zwei bis zehn-mal kleineren Durchmesser der Kristallkörner der poly-Si Schicht, deutlich größer ist; und/oder dass die dabei gebildete Schicht eine größere Dichte von Korngrenzen aufweist, als eine oder mehr als eine an die gebildete Schicht angrenzende Schicht (die z.B. das Dielektrikum aufweist und/oder ein anderes Dielektrikum aufweist).

Beispiel 66 ist eingerichtet gemäß einem der Beispiele 1 bis 65, wobei das Sputtertarget den Dotanten des Halbleitermaterials in aktivierter Form in der Menge aufweist.

Beispielsweise kann die Menge des Dotanten, der aktiviert ist, größer sein als die Löslichkeitsgrenze des Dotanten in dem Halbleitermaterial und/oder als der Stoffmengenanteil des Dotanten von 0,15 at%.

Beispiel 67 ist eingerichtet gemäß einem der Beispiele 1 bis 66, wobei die Menge S_{M} des Dotanten und die Löslichkeitsgrenze SG des Dotanten in dem Halbleitermaterial folgender Relation genügen: S_{M} > k·S_{G}, wobei k>1 ist, vorzugsweise k>1,1 oder k>1,2 oder k>1,3 ist, weiter vorzugsweise k>1,4 oder k>1,5 oder k>1,6 ist, noch weiter vorzugsweise k>1,7 oder k>1,8 oder k>1,9 ist, noch weiter vorzugsweise k>3 oder k>5 oder k>8 ist. Die Löslichkeitsgrenze S_{G} kann beispielsweise 10²⁰ at/cm³ oder weniger sein.

Beispiel 68 ist eingerichtet gemäß einem der Beispiele 1 bis 67, wobei zwischen dem Beschichtungsbereich und dem Sputtertarget eine Blendenvorrichtung angeordnet ist, welche eine Blendenöffnung aufweist (beispielsweise durch welche hindurch das Zerstäuben des Sputtertargets in den Beschichtungsbereich hinein erfolgt), wobei die Blendenvorrichtung vorzugsweise eingerichtet ist, den Beschichtungsbereich und/oder den Solarzellenpräkursor gegenüber dem Zerstäuben des Sputtertargets abzuschatten, wobei die Blendenvorrichtung vorzugsweise eingerichtet ist, mittels des Zerstäubens des Sputtertargets beschichtet zu werden.

Beispiel 69 ist eingerichtet gemäß Beispiel 68, wobei die Blendenvorrichtung eingerichtet ist, mittels des Zerstäubens des Sputtertargets beschichtet zu werden mit einem ersten Materialstrom (beispielsweise der von dem Sputtertarget stammt), wobei mittels des Zerstäubens des Sputtertargets ein zweiter Materialstrom in den Beschichtungsbereich hinein bereitgestellt wird, wobei der erste Materialstrom X% des zweiten Materialstroms ist, wobei X größer ist als 5% (oder 10%), z.B. als ungefähr 15% (oder 25%), und/oder kleiner ist als ungefähr 50% (oder 30%), z.B. als ungefähr 20% (oder 10%). Beispielsweise können der erste und zweite Materialstrom ein Massenstrom (Masse pro Zeit) sein.

Beispiel 70 ist eingerichtet gemäß einem der Beispiele 1 bis 69, wobei von dem mittels des Zerstäuben des Sputtertargets erzeugten Materialstroms mehr als ungefähr 5% (oder 10%), z.B. mehr als ungefähr 15% (oder 25%) aufgefangen wird (z.B. bevor dieses den Beschichtungsbereich und/oder den Solarzellenpräkursor erreicht), z.B. von der Blendenvorrichtung und/oder dem Substratträger (welche dann dazu eingerichtet sind).

Beispiel 71 ist eingerichtet gemäß einem der Beispiele 1 bis 70, wobei von dem mittels des Zerstäuben des Sputtertargets erzeugten Materialstroms weniger als ungefähr 50% (oder 30%), z.B. weniger als ungefähr 20% (oder 10%) aufgefangen wird (z.B. bevor dieses den Beschichtungsbereich und/oder den Solarzellenpräkursor erreicht), z.B. von der Blendenvorrichtung und/oder dem Substratträger (welche dann dazu eingerichtet sind).

In einem zusätzlichen exemplarischen Beispiel ist eine Anlage für ein Verfahren eingerichtet zur Verwendung bei der Herstellung von Solarzellen, welche mindestens einen sogenannten passivierten Kontakt aufweisen, das Verfahren aufweisend: Zerstäuben eines Sputtertargets in einen Beschichtungsbereich hinein, wobei das Sputtertarget ein Halbleitermaterial und einen n-leitenden Dotanten des Halbleitermaterials in einer Konzentration aufweist, die größer ist als 7·10¹⁹ at/cm³, vorzugsweise größer als 2,35·10²⁰ at/cm³ (kann beispielsweise ca. 0,5gew% P in Si entsprechen); Anordnen des Solarzellenpräkursors in dem Beschichtungsbereich, wenn das Sputtertarget in diesen hinein zerstäubt wird, wobei die zu beschichtende Seite (oder die zu beschichtenden Seiten) dem Sputtertarget (den Sputtertargets) zugewandt ist (sind); die Anlage kann optional dadurch gekennzeichnet sein, dass: mehr als 3000 Substrate pro Stunde mit einer Kantenlänge >180mm vorzugsweise mehr als 6000 Substrate pro Stunde beschichtet werden; und die senkrechte Kante des Solarzellenpräkursor und/ oder eine die Rückseite umlaufende laterale Fläche des Solarzellenpräkursor im Wesentlichen nicht beschichtet wird, wenn der Solarzellenpräkursor in dem Beschichtungsbereich angeordnet ist.

Die Anlage erreicht die Vermeidung des elektrischen Kurzschlusses bzw. eines erhöhten Rückwärtsstroms der fertigen Solarzelle.

In dem zusätzlichen exemplarischen Beispiel kann ferner:
- der n-Dotant vorzugsweise Phosphor oder Arsen sein;
- die Dicke der aSi-Schicht vorzugsweise zwischen 5 nm und 200 nm ausgebildet sein;
- die Prozessierung vorzugsweise ohne zusätzliche Heizelemente im Sputterprozess, also Substratzuführung bei Raumtemperatur und ohne Heizung während des Beschichtungsprozess erfolgen;
- die Zykluszeit zur Abscheidung der gewünschten Schicht vorzugsweise im inline-Verfahren kleiner sein als 45 Sekunden;
- vorzugsweise eine Kammer für beidseitige Beschichtung des aSi durch gleichzeitiges Sputtern von vorne (z.B. n-typ dotiert) und von hinten (z.B. p-typ dotiert) vorgesehen sein, was auch die Schichteigenschaften verbessert.

## Patentansprüche

1. Verfahren (300) zum Bearbeiten eines Solarzellenpräkursors (402), welcher eine mit zumindest einem Dielektrikum bedeckte Seite aufweist, das Verfahren (300) aufweisend:
• Zerstäuben (303) eines Sputtertargets (404) in einen Beschichtungsbereich (401) hinein, wobei das Sputtertarget (404) ein Halbleitermaterial aufweist;
• wobei das Sputtertarget (404) ferner einen Dotanten des Halbleitermaterials aufweist in einer Menge, die größer ist als eine Löslichkeitsgrenze des Dotanten in dem Halbleitermaterial und/oder als ein Stoffmengenanteil des Dotanten von 0,15 at%;
• Anordnen (305) des Solarzellenpräkursors (402), der in einem Substratträger eingelegt ist, in dem Beschichtungsbereich (401), wenn das Zerstäuben des Sputtertargets (404) in den Beschichtungsbereich (401) hinein erfolgt derart, dass die Seite dem Sputtertarget (404) zugewandt ist;
• wobei der Substratträger derart eingerichtet ist, dass eine entlang eines in sich geschlossenen Pfades verlaufende Kante (510k, 512k) des Solarzellenpräkursors (402) mittels des Substratträgers gegenüber dem Zerstäuben des Sputtertargets (404) abgeschattet wird.

2. Verfahren (300) gemäß Anspruch 1,
• wobei der Substratträger eine Verschattungsmaske, mittels welcher die Kante (510k, 512k) des Solarzellenpräkursors abgeschattet wird, aufweist, durch welche das Sputtertarget (404) hindurch zu dem Solarzellenpräkursor (402) hin zerstäubt wird;
• wobei vorzugsweise die Verschattungsmaske eine Öffnung (406o, 416o) aufweist, welche den Solarzellenpräkursor (402) gegenüber dem Sputtertarget (404) freilegt.

3. Verfahren (300) gemäß Anspruch 1 oder 2, wobei der Solarzellenpräkursor (402), wenn dieser in dem Beschichtungsbereich (401) angeordnet ist, eine Temperatur von weniger als ungefähr 200°C, vorzugsweise weniger als ungefähr 100°C, und/oder von weniger als einer Temperatur des Sputtertargets (404) aufweist.

4. Verfahren (300) gemäß einem der Ansprüche 1 bis 3, ferner aufweisend:
• Bilden einer Schicht (108) auf dem Solarzellenpräkursor (402) mittels des Zerstäubens des Sputtertargets (404), wobei die Schicht (108) ein kleineres Mengenverhältnis des Dotanten zu dem Halbleitermaterial aufweist als das Sputtertarget (404) oder dasselbe Mengenverhältnis;
• wobei vorzugsweise die Schicht (108) zumindest teilweise amorph ist und/oder einen Schichtwiderstand von mindestens 1000 Ohm aufweist.

5. Verfahren (300) gemäß Anspruch 4, wobei die Schicht (108) eine Konzentration des Dotanten aufweist die größer ist als 7·10¹⁹ at/cm³, vorzugsweise als >1·10²⁰ at/cm³.

6. Verfahren gemäß einem der Ansprüche 1 bis 5, wobei der Solarzellenpräkursor (402) in dem Beschichtungsbereich (401) einer chemischen Zusammensetzung ausgesetzt ist, die weniger Wasserstoffatome als Atome des Dotanten aufweist, vorzugsweise im Wesentlichen frei von Wasserstoff ist.

7. Verfahren (300) gemäß einem der Ansprüche 1 bis 6, wobei die Seite des Solarzellenpräkursors (402) mittels einer dielektrischen Schicht (106) aus dem zumindest einen Dielektrikum beschichtet ist, welche eine Dicke von weniger als 5 Nanometer, vorzugsweise weniger als 2,5 Nanometer, aufweist.

8. Verfahren (300) gemäß einem der Ansprüche 1 bis 7, wobei der Dotant Phosphor aufweist oder Phosphor ist.

9. Verfahren (300) gemäß einem der Ansprüche 1 bis 8, wobei die Kante (510k, 512k) des Solarzellenpräkursors (402) im Wesentlichen nicht beschichtet wird, wenn der Solarzellenpräkursor (402) in dem Beschichtungsbereich (401) angeordnet ist.

10. Verfahren (300) gemäß einem der Ansprüche 1 bis 9, wobei der Solarzellenpräkursor (402), wenn dieser in dem Beschichtungsbereich (401) angeordnet ist, eine Temperatur von weniger als ungefähr 200°C und/oder von weniger als einer Temperatur des Sputtertargets (404) aufweist.

11. Verwenden eines Vakuumsystems zum Durchführen des Verfahrens (300) gemäß einem der Ansprüche 1 bis 10, wobei das Vakuumsystem aufweist:
• eine oder mehr als eine Vakuumkammer, in welcher der Beschichtungsbereich angeordnet ist, und
• eine Sputtervorrichtung mit dem Sputtertarget.

12. Vakuumsystem, aufweisend:
• eine oder mehr als eine Vakuumkammer, in welcher ein Beschichtungsbereich angeordnet ist;
• eine Sputtervorrichtung, welche ein Sputtertarget aufweist und eingerichtet ist, das Sputtertarget in den Beschichtungsbereich hinein zu zerstäuben;
• wobei das Sputtertarget (404) ein Halbleitermaterial aufweist, wobei das Sputtertarget (404) ferner einen Dotanten des Halbleitermaterials aufweist in einer Menge, die größer ist als eine Löslichkeitsgrenze des Dotanten in dem Halbleitermaterial und/oder als ein Stoffmengenanteil des Dotanten von 0,15 at%;
• ein Transportsystem, welches einen Substratträger aufweist und eingerichtet ist zum Transportieren eines Solarzellenpräkursors (402), der in dem Substratträger eingelegt ist, in dem Beschichtungsbereich (401), wenn das Zerstäuben des Sputtertargets (404) in den Beschichtungsbereich (401) hinein erfolgt, vorzugsweise derart, dass eine mit zumindest einem Dielektrikum beschichtete Seite des Solarzellenpräkursors dem Sputtertarget (404) zugewandt ist;
• wobei der Substratträger derart eingerichtet ist, dass eine entlang eines in sich geschlossenen Pfades verlaufende Kante (510k, 512k) des Solarzellenpräkursors (402) mittels des Substratträgers gegenüber dem Zerstäuben des Sputtertargets (404) abgeschattet wird.

13. Vakuumsystem gemäß Anspruch 12,
• wobei der Substratträger eine Verschattungsmaske aufweist, mittels welcher die Kante abgeschattet wird und/oder durch welche das Sputtertarget hindurch zerstäubt wird; und/oder
• wobei der Substratträger eine Öffnung aufweist, welche den Solarzellenpräkursor gegenüber dem Sputtertarget freilegt, wobei die Öffnung von einer konvexen Fläche des Substratträgers begrenzt wird.

14. Vakuumsystem gemäß Anspruch 12 oder 13, wobei ein Soll-Zustand des Vakuumsystems im Betrieb derart eingerichtet ist, dass eine Temperatur des Solarzellenpräkursor (402), wenn dieser in dem Beschichtungsbereich (401) angeordnet wird, weniger ist als ungefähr 200°C, vorzugsweise als ungefähr 100°C, und/oder weniger ist als eine Temperatur des Sputtertargets (404).

15. Vakuumsystem gemäß einem der Ansprüche 12 bis 14, ferner aufweisend:
• eine Gastransfervorrichtung, welche eine Schnellkupplung aufweist und eingerichtet ist, dem Beschichtungsbereich eine Gaszusammensetzung zuzuführen und/oder zu entziehen durch die Schnellkupplung hindurch;
• vorzugsweise ein einwandiges Rohr, mittels welchem der Beschichtungsbereich mit der Gastransfervorrichtung gekoppelt ist.

## Geänderte Patentansprüche

### Geänderte Patentansprüche gemäss Regel 137(2) EPÜ.

**1.** Verfahren (300) zum Bearbeiten eines Solarzellenpräkursors (402), welcher eine mit zumindest einem Dielektrikum bedeckte Seite aufweist, das Verfahren (300) aufweisend:
• Zerstäuben (303) eines Sputtertargets (404) in einen Beschichtungsbereich (401) hinein, wobei das Sputtertarget (404) ein Halbleitermaterial aufweist;
• wobei das Sputtertarget (404) ferner einen Dotanten des Halbleitermaterials aufweist in einer Menge, die größer ist als eine Löslichkeitsgrenze des Dotanten in dem Halbleitermaterial und/oder als ein Stoffmengenanteil des Dotanten von 0,15 at%;
• Anordnen (305) des Solarzellenpräkursors (402), der in einem Substratträger eingelegt ist, in dem Beschichtungsbereich (401), wenn das Zerstäuben des Sputtertargets (404) in den Beschichtungsbereich (401) hinein erfolgt derart, dass die Seite dem Sputtertarget (404) zugewandt ist;
• wobei der Substratträger derart eingerichtet ist, dass eine entlang eines in sich geschlossenen Pfades verlaufende Kante (510k, 512k) des Solarzellenpräkursors (402), entlang welcher das Dielektrikum des Solarzellenpräkursors (402) freiliegt, mittels des Substratträgers gegenüber dem Zerstäuben des Sputtertargets (404) abgeschattet wird.

**2.** Verfahren (300) gemäß Anspruch 1,
• wobei der Substratträger eine Verschattungsmaske, mittels welcher die Kante (510k, 512k) des Solarzellenpräkursors abgeschattet wird, aufweist, durch welche das Sputtertarget (404) hindurch zu dem Solarzellenpräkursor (402) hin zerstäubt wird;
• wobei vorzugsweise die Verschattungsmaske eine Öffnung (406o, 416o) aufweist, welche den Solarzellenpräkursor (402) gegenüber dem Sputtertarget (404) freilegt.

**3.** Verfahren (300) gemäß Anspruch 1 oder 2, wobei der Solarzellenpräkursor (402), wenn dieser in dem Beschichtungsbereich (401) angeordnet ist, eine Temperatur von weniger als ungefähr 200°C, vorzugsweise weniger als ungefähr 100°C, und/oder von weniger als einer Temperatur des Sputtertargets (404) aufweist.

**4.** Verfahren (300) gemäß einem der Ansprüche 1 bis 3, ferner aufweisend:
• Bilden einer Schicht (108) auf dem Solarzellenpräkursor (402) mittels des Zerstäubens des Sputtertargets (404), wobei die Schicht (108) ein kleineres Mengenverhältnis des Dotanten zu dem Halbleitermaterial aufweist als das Sputtertarget (404) oder dasselbe Mengenverhältnis;
• wobei vorzugsweise die Schicht (108) zumindest teilweise amorph ist und/oder einen Schichtwiderstand von mindestens 1000 Ohm aufweist.

**5.** Verfahren (300) gemäß Anspruch 4, wobei die Schicht (108) eine Konzentration des Dotanten aufweist die größer ist als 7·10¹⁹ at/cm³, vorzugsweise als >1·10²⁰ at/cm³.

**6.** Verfahren gemäß einem der Ansprüche 1 bis 5, wobei der Solarzellenpräkursor (402) in dem Beschichtungsbereich (401) einer chemischen Zusammensetzung ausgesetzt ist, die weniger Wasserstoffatome als Atome des Dotanten aufweist, vorzugsweise im Wesentlichen frei von Wasserstoff ist.

**7.** Verfahren (300) gemäß einem der Ansprüche 1 bis 6, wobei die Seite des Solarzellenpräkursors (402) mittels einer dielektrischen Schicht (106) aus dem zumindest einen Dielektrikum beschichtet ist, welche eine Dicke von weniger als 5 Nanometer, vorzugsweise weniger als 2,5 Nanometer, aufweist.

**8.** Verfahren (300) gemäß einem der Ansprüche 1 bis 7, wobei der Dotant Phosphor aufweist oder Phosphor ist.

**9.** Verfahren (300) gemäß einem der Ansprüche 1 bis 8, wobei die Kante (510k, 512k) des Solarzellenpräkursors (402) im Wesentlichen nicht beschichtet wird, wenn der Solarzellenpräkursor (402) in dem Beschichtungsbereich (401) angeordnet ist.

**10.** Verfahren (300) gemäß einem der Ansprüche 1 bis 9, wobei der Solarzellenpräkursor (402), wenn dieser in dem Beschichtungsbereich (401) angeordnet ist, eine Temperatur von weniger als ungefähr 200°C und/oder von weniger als einer Temperatur des Sputtertargets (404) aufweist.

**11.** Verwenden eines Vakuumsystems zum Durchführen des Verfahrens (300) gemäß einem der Ansprüche 1 bis 10, wobei das Vakuumsystem aufweist:
• eine oder mehr als eine Vakuumkammer, in welcher der Beschichtungsbereich angeordnet ist, und
• eine Sputtervorrichtung mit dem Sputtertarget.

**12.** Vakuumsystem, aufweisend:
• eine oder mehr als eine Vakuumkammer, in welcher ein Beschichtungsbereich angeordnet ist;
• eine Sputtervorrichtung, welche ein Sputtertarget (404) aufweist und eingerichtet ist, das Sputtertarget in den Beschichtungsbereich hinein zu zerstäuben;
• wobei das Sputtertarget (404) ein Halbleitermaterial aufweist, wobei das Sputtertarget (404) ferner einen Dotanten des Halbleitermaterials aufweist in einer Menge, die größer ist als eine Löslichkeitsgrenze des Dotanten in dem Halbleitermaterial und/oder als ein Stoffmengenanteil des Dotanten von 0,15 at%;
• ein Transportsystem, welches einen Substratträger aufweist und eingerichtet ist zum Transportieren eines Solarzellenpräkursors (402), der in dem Substratträger eingelegt ist, in dem Beschichtungsbereich (401), wenn das Zerstäuben des Sputtertargets (404) in den Beschichtungsbereich (401) hinein erfolgt, vorzugsweise derart, dass eine mit zumindest einem Dielektrikum beschichtete Seite des Solarzellenpräkursors dem Sputtertarget (404) zugewandt ist;
• wobei der Substratträger derart eingerichtet ist, dass eine entlang eines in sich geschlossenen Pfades verlaufende Kante (510k, 512k) des Solarzellenpräkursors (402) mittels des Substratträgers gegenüber dem Zerstäuben des Sputtertargets (404) abgeschattet wird.

**13.** Vakuumsystem gemäß Anspruch 12,
• wobei der Substratträger eine Verschattungsmaske aufweist, mittels welcher die Kante abgeschattet wird und/oder durch welche das Sputtertarget hindurch zerstäubt wird; und/oder
• wobei der Substratträger eine Öffnung aufweist, welche den Solarzellenpräkursor gegenüber dem Sputtertarget freilegt, wobei die Öffnung von einer konvexen Fläche des Substratträgers begrenzt wird.

**14.** Vakuumsystem gemäß Anspruch 12 oder 13, wobei ein Soll-Zustand des Vakuumsystems im Betrieb derart eingerichtet ist, dass eine Temperatur des Solarzellenpräkursor (402), wenn dieser in dem Beschichtungsbereich (401) angeordnet wird, weniger ist als ungefähr 200°C, vorzugsweise als ungefähr 100°C, und/oder weniger ist als eine Temperatur des Sputtertargets (404).

**15.** Vakuumsystem gemäß einem der Ansprüche 12 bis 14, ferner aufweisend:
• eine Gastransfervorrichtung, welche eine Schnellkupplung aufweist und eingerichtet ist, dem Beschichtungsbereich eine Gaszusammensetzung zuzuführen und/oder zu entziehen durch die Schnellkupplung hindurch;
• vorzugsweise ein einwandiges Rohr, mittels welchem der Beschichtungsbereich mit der Gastransfervorrichtung gekoppelt ist.

**1.** Verfahren (300) zum Bearbeiten eines Solarzellenpräkursors (402), welcher eine mit zumindest einem Dielektrikum bedeckte Seite aufweist, das Verfahren (300) aufweisend:
• Zerstäuben (303) eines Sputtertargets (404) in einen Beschichtungsbereich (401) hinein, wobei das Sputtertarget (404) ein Halbleitermaterial aufweist;
• wobei das Sputtertarget (404) ferner einen Dotanten des Halbleitermaterials aufweist in einer Menge, die größer ist als eine Löslichkeitsgrenze des Dotanten in dem Halbleitermaterial und/oder als ein Stoffmengenanteil des Dotanten von 0,15 at%;
• Anordnen (305) des Solarzellenpräkursors (402), der in einem Substratträger eingelegt ist, in dem Beschichtungsbereich (401), wenn das Zerstäuben des Sputtertargets (404) in den Beschichtungsbereich (401) hinein erfolgt derart, dass die Seite dem Sputtertarget (404) zugewandt ist;
• wobei der Substratträger derart eingerichtet ist, dass eine entlang eines in sich geschlossenen Pfades verlaufende Kante (510k, 512k) des Solarzellenpräkursors (402) mittels des Substratträgers gegenüber dem Zerstäuben des Sputtertargets (404) abgeschattet wird.

**2.** Verfahren (300) gemäß Anspruch 1,
• wobei der Substratträger eine Verschattungsmaske, mittels welcher die Kante (510k, 512k) des Solarzellenpräkursors abgeschattet wird, aufweist, durch welche das Sputtertarget (404) hindurch zu dem Solarzellenpräkursor (402) hin zerstäubt wird;
• wobei vorzugsweise die Verschattungsmaske eine Öffnung (406o, 416o) aufweist, welche den Solarzellenpräkursor (402) gegenüber dem Sputtertarget (404) freilegt.

**3.** Verfahren (300) gemäß Anspruch 1 oder 2, wobei der Solarzellenpräkursor (402), wenn dieser in dem Beschichtungsbereich (401) angeordnet ist, eine Temperatur von weniger als ungefähr 200°C, vorzugsweise weniger als ungefähr 100°C, und/oder von weniger als einer Temperatur des Sputtertargets (404) aufweist.

**4.** Verfahren (300) gemäß einem der Ansprüche 1 bis 3, ferner aufweisend:
• Bilden einer Schicht (108) auf dem Solarzellenpräkursor (402) mittels des Zerstäubens des Sputtertargets (404), wobei die Schicht (108) ein kleineres Mengenverhältnis des Dotanten zu dem Halbleitermaterial aufweist als das Sputtertarget (404) oder dasselbe Mengenverhältnis;
• wobei vorzugsweise die Schicht (108) zumindest teilweise amorph ist und/oder einen Schichtwiderstand von mindestens 1000 Ohm aufweist.

**5.** Verfahren (300) gemäß Anspruch 4, wobei die Schicht (108) eine Konzentration des Dotanten aufweist die größer ist als 7·10¹⁹ at/cm³, vorzugsweise als >1·10²⁰ at/cm³.

**6.** Verfahren gemäß einem der Ansprüche 1 bis 5, wobei der Solarzellenpräkursor (402) in dem Beschichtungsbereich (401) einer chemischen Zusammensetzung ausgesetzt ist, die weniger Wasserstoffatome als Atome des Dotanten aufweist, vorzugsweise im Wesentlichen frei von Wasserstoff ist.

**7.** Verfahren (300) gemäß einem der Ansprüche 1 bis 6, wobei die Seite des Solarzellenpräkursors (402) mittels einer dielektrischen Schicht (106) aus dem zumindest einen Dielektrikum beschichtet ist, welche eine Dicke von weniger als 5 Nanometer, vorzugsweise weniger als 2,5 Nanometer, aufweist.

**8.** Verfahren (300) gemäß einem der Ansprüche 1 bis 7, wobei der Dotant Phosphor aufweist oder Phosphor ist.

**9.** Verfahren (300) gemäß einem der Ansprüche 1 bis 8, wobei die Kante (510k, 512k) des Solarzellenpräkursors (402) im Wesentlichen nicht beschichtet wird, wenn der Solarzellenpräkursor (402) in dem Beschichtungsbereich (401) angeordnet ist.

**10.** Verfahren (300) gemäß einem der Ansprüche 1 bis 9, wobei der Solarzellenpräkursor (402), wenn dieser in dem Beschichtungsbereich (401) angeordnet ist, eine Temperatur von weniger als ungefähr 200°C und/oder von weniger als einer Temperatur des Sputtertargets (404) aufweist.

**11.** Verwenden eines Vakuumsystems zum Durchführen des Verfahrens (300) gemäß einem der Ansprüche 1 bis 10, wobei das Vakuumsystem aufweist:
• eine oder mehr als eine Vakuumkammer, in welcher der Beschichtungsbereich angeordnet ist, und
• eine Sputtervorrichtung mit dem Sputtertarget.

**12.** Vakuumsystem, aufweisend:
• eine oder mehr als eine Vakuumkammer, in welcher ein Beschichtungsbereich angeordnet ist;
• eine Sputtervorrichtung, welche ein Sputtertarget (404) aufweist und eingerichtet ist, das Sputtertarget in den Beschichtungsbereich hinein zu zerstäuben;
• wobei das Sputtertarget (404) ein Halbleitermaterial aufweist, wobei das Sputtertarget (404) ferner einen Dotanten des Halbleitermaterials aufweist in einer Menge, die größer ist als eine Löslichkeitsgrenze des Dotanten in dem Halbleitermaterial und/oder als ein Stoffmengenanteil des Dotanten von 0,15 at%;
• ein Transportsystem, welches einen Substratträger aufweist und eingerichtet ist zum Transportieren eines Solarzellenpräkursors (402), der in dem Substratträger eingelegt ist, in dem Beschichtungsbereich (401), wenn das Zerstäuben des Sputtertargets (404) in den Beschichtungsbereich (401) hinein erfolgt, vorzugsweise derart, dass eine mit zumindest einem Dielektrikum beschichtete Seite des Solarzellenpräkursors dem Sputtertarget (404) zugewandt ist;
• wobei der Substratträger derart eingerichtet ist, dass eine entlang eines in sich geschlossenen Pfades verlaufende Kante (510k, 512k) des Solarzellenpräkursors (402) mittels des Substratträgers gegenüber dem Zerstäuben des Sputtertargets (404) abgeschattet wird,
• wobei der Substratträger eine Verschattungsmaske aufweist, mittels welcher die Kante abgeschattet wird und/oder durch welche das Sputtertarget (404) hindurch zerstäubt wird; und/oder
• wobei der Substratträger eine Öffnung aufweist, welche den Solarzellenpräkursor (402) gegenüber dem Sputtertarget (404) freilegt, wobei die Öffnung von einer konvexen Fläche des Substratträgers begrenzt wird, und
• wobei die Verschattungsmaske mittels einer Substratauflage des Substratträgers, auf welcher der Solarzellenpräkursor (402) aufliegt, bereitgestellt wird, oder wobei die Verschattungsmaske eine Öffnung aufweist, in welcher der Solarzellenpräkursor (402) eingelegt ist.

**13.** Vakuumsystem gemäß Anspruch 12, wobei ein Soll-Zustand des Vakuumsystems im Betrieb derart eingerichtet ist, dass eine Temperatur des Solarzellenpräkursor (402), wenn dieser in dem Beschichtungsbereich (401) angeordnet wird, weniger ist als ungefähr 200°C, vorzugsweise als ungefähr 100°C, und/oder weniger ist als eine Temperatur des Sputtertargets (404).

**14.** Vakuumsystem gemäß Anspruch 12 oder 13, ferner aufweisend:
• eine Gastransfervorrichtung, welche eine Schnellkupplung aufweist und eingerichtet ist, dem Beschichtungsbereich eine Gaszusammensetzung zuzuführen und/oder zu entziehen durch die Schnellkupplung hindurch;
• vorzugsweise ein einwandiges Rohr, mittels welchem der Beschichtungsbereich mit der Gastransfervorrichtung gekoppelt ist.
